(19) Europäisches Patentamt
European Patent Office
Office européen des brevets

(11) **EP 4 686 370 A1**

(12) **EUROPEAN PATENT APPLICATION**

(43) Date of publication:
28.01.2026 Bulletin 2026/05

(21) Application number: 25186327.0

(22) Date of filing: 30.06.2025

(51) International Patent Classification (IPC):
*H10N 30/076* (2023.01)　　*H10N 30/079* (2023.01)
*H10N 30/00* (2023.01)　　*H10N 30/853* (2023.01)
*H10N 30/20* (2023.01)

(52) Cooperative Patent Classification (CPC):
**H10N 30/8542; H10N 30/076; H10N 30/079;**
**H10N 30/708;** H10N 30/2042; H10N 30/2047

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: 26.07.2024 JP 2024121390

(71) Applicant: **Sumitomo Chemical Company, Limited**
**Tokyo 103-6020 (JP)**

(72) Inventors:
• **SHIBATA, Kenji**
**Hitachi-shi, Ibaraki, 3191418 (JP)**
• **WATANABE, Kazutoshi**
**Hitachi-shi, Ibaraki, 3191418 (JP)**
• **KURODA, Toshiaki**
**Hitachi-shi, Ibaraki, 3191418 (JP)**
• **TANAKA, Yasunori**
**Hitachi-shi, Ibaraki, 3191418 (JP)**

(74) Representative: **Vossius & Partner**
**Patentanwälte Rechtsanwälte mbB**
**Siebertstrasse 3**
**81675 München (DE)**

(54) **PIEZOELECTRIC STACK AND METHOD FOR MANUFACTURING THE PIEZOELECTRIC STACK**

(57) There is provided a piezoelectric stack (10) including: a substrate (1)0; a bottom electrode film (2) on the substrate (1); and a piezoelectric film (3) on the bottom electrode film (2), the piezoelectric film (3) being composed of a perovskite-type oxide represented by a general formula $ABO_3$, with A site containing K and Na, and B site containing Nb, wherein when the piezoelectric film (3) is divided into a surface layer region (3a) extending from an upper surface of the piezoelectric film (3) to a predetermined depth toward the substrate (1), and a bulk region (3b) which is a region other than the surface layer region (3a), a total atomic concentration of K and Na in the surface layer region (3a) is higher than a total atomic concentration of K and Na in the bulk region (3b).

**FIG. 1**

EP 4 686 370 A1

**Description**

Technical Field

The present disclosure relates to a piezoelectric stack and a method for manufacturing the piezoelectric stack.

Description of Related Art

A piezoelectric material is widely used in functional electronic components (devices) such as a sensor and actuator. One of the piezoelectric materials used is a ferroelectric material (i.e., a KNN-based ferroelectric material) that is composed of a perovskite-type oxide represented by a general formula $ABO_3$, with A site containing K and Na, and B site containing Nb. Then, a stack having a piezoelectric film (KNN film) deposited using a KNN-based ferroelectric material, has been proposed. The KNN film is required to be resistant to dielectric breakdown even when a voltage is applied to the KNN film for a long period of time. That is, the KNN film is required to have a long DC stress life (high DC stress resistance). Therefore, techniques for improving the DC stress resistance of the KNN film have been proposed (see, for example, Patent documents 1 and 2).

Prior art document

Patent document

[Patent Document 1] JP 2017-076730 A
[Patent Document 2] JP 2018-207055 A

Summary of the invention

Problem to be solved by the invention

Actuators and sensors manufactured by processing the above-described stack are sometimes required to operate normally for a long period of time in a high temperature and high humidity environment, that is, to have a long DC stress life even in the high temperature and high humidity environment. However, the KNN film obtained by the above-described technique has low DC stress resistance in the high temperature and high humidity environment (short DC stress life).

An object of the present disclosure is to provide a piezoelectric stack having a piezoelectric film with improved DC stress life under a high temperature and high humidity environment.

Means for solving the problem

According to one embodiment of the present disclosure, there is provided a piezoelectric stack including:

a substrate;
a bottom electrode film on the substrate; and
a piezoelectric film on the bottom electrode film, the piezoelectric film being composed of a perovskite-type oxide represented by a general formula $ABO_3$, with A site containing K and Na, and B site containing Nb,
wherein when the piezoelectric film is divided into a surface layer region extending from an upper surface of the piezoelectric film to a predetermined depth toward the substrate, and a bulk region which is a region other than the surface layer region, a total atomic concentration of K and Na in the surface layer region is higher than a total atomic concentration of K and Na in the bulk region.

According to another embodiment of the present disclosure, there is provided a method for manufacturing a piezoelectric stack, including:

preparing a substrate;
preparing a target composed of a perovskite-type oxide represented by a general formula $ABO_3$, with A site containing K and Na, and B site containing Nb;
depositing a bottom electrode film on the substrate; and

depositing a piezoelectric film composed of a perovskite-type oxide represented by a general formula $ABO_3$, with A site containing K and Na, and B site containing Nb, on the bottom electrode film by a sputtering method using the target,

wherein in the preparation of the target,

a first target, and a second target in which a ratio of a total number of K atoms and Na atoms contained per unit volume with respect to the number of Nb atoms contained per unit volume is smaller than that of the first target, are prepared, and

in the deposition of the piezoelectric film,

(a) applying equal power to the first target and the second target; and (b) applying a power to the first target that is greater than a power to the second target, are performed in this order by using the first target and the second target, wherein (b) is started immediately before an end of deposition of the piezoelectric film.

Advantage of the invention

The present disclosure provides a piezoelectric film with improved DC stress life under a high temperature and high humidity environment.

Brief description of the drawings

FIG. 1 is a view illustrating an example of a cross-sectional structure of a piezoelectric stack according to one embodiment of the present disclosure.

FIG. 2 is a view illustrating an example of a structure of a simple piezoelectric element according to one embodiment of the present disclosure.

FIG. 3 is a view illustrating an example of a schematic structure of a piezoelectric element according to one embodiment of the present disclosure.

FIG. 4 is a view illustrating an example of a schematic structure of a piezoelectric device module according to one embodiment of the present disclosure.

FIG. 5 is a view illustrating an example of a cross-sectional structure of a piezoelectric stack according to a modified example of one embodiment of the present disclosure.

FIG. 6 (a) is a view illustrating an example of a schematic structure of a simple unimorph cantilever fabricated using each sample, and FIG. 6 (b) is a view explaining a method for measuring an amount of piezoelectric displacement.

Detailed description of the invention

<One embodiment of the present disclosure>

Hereinafter, one embodiment of the present disclosure will be described with reference to the drawings.

(1) A structure of the piezoelectric stack

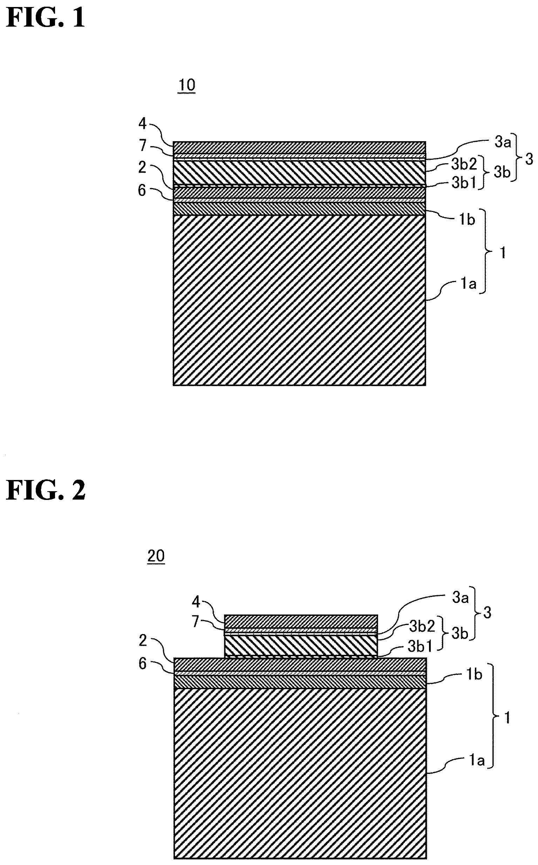

As illustrated in FIG. 1, a stack 10 having a piezoelectric film according to this embodiment (hereinafter also referred to as a piezoelectric stack 10) includes a substrate 1, a bottom electrode film 2, a piezoelectric film (piezoelectric thin film) 3, and a top electrode film 4.

As the substrate 1, a single crystal silicon (Si) substrate 1a having a surface oxide film ($SiO_2$ film) 1b such as a thermal oxide film or a CVD (Chemical Vapor Deposition) oxide film, i.e., a Si substrate having a surface oxide film, can be suitably used. Also, as the substrate 1, a Si substrate 1a having an insulating film composed of an insulating material other than $SiO_2$ instead of the surface oxide film 1b, can be used. Also, as the substrate 1, a Si substrate 1a having an exposed Si (100) or Si (111), i.e., a Si substrate having no surface oxide film 1b or insulating film can be used. Also, as the substrate 1, a SOI (Silicon On Insulator) substrate and a quartz glass ($SiO_2$) substrate can be used. The thickness of the single crystal Si substrate 1a may be, for example, 300 $\mu$m or more and 1000 $\mu$m or less, and the thickness of the surface oxide film 1b may be, for example, 1 nm or more and 4000 nm or less.

The bottom electrode film 2 is deposited on the substrate 1. That is, the bottom electrode film 2 is provided between the substrate 1 and the piezoelectric film 3. The bottom electrode film 2 can be formed using, for example, platinum (Pt) and is a polycrystalline film. Hereinafter, the polycrystalline film deposited using Pt is also referred to as a Pt film. It is preferable that (111) of the Pt film is parallel to the main surface of the substrate 1 (including a case where (111) is inclined at an angle of $\pm5°$ or less with respect to the main surface of the substrate 1), that is, the Pt film is oriented in a (111) orientation. The Pt film being oriented in the (111) orientation means that no peaks other than those caused by (111) are observed in an X-ray diffraction pattern obtained by X-ray diffraction (XRD), measured on the surface of the piezoelectric film 3. Thus, it is preferable that the main surface of the bottom electrode film 2 (the surface serving as the base for the piezoelectric film 3) is composed of Pt(111). The bottom electrode film 2 can be deposited by a technique such as a sputtering method or a vapor deposition method. As a material for the bottom electrode film 2, other than Pt, various metals such as gold (Au), ruthenium (Ru), or iridium (Ir), alloys mainly composed of those metals, or metal oxides such as strontium ruthenium oxide ($SrRuO_3$, abbreviated as SRO) or lanthanum nickel oxide ($LaNiO_3$, abbreviated as LNO) can also be used. When the bottom electrode film 2 is deposited using a metal oxide, it is preferable that the crystals constituting the bottom electrode film 2 are preferentially oriented in the (001) orientation with respect to the surface of the substrate 1. That is, the main surface of the bottom electrode film 2 is preferably mainly composed of SRO(001) or LNO(001). The crystals constituting the bottom electrode film 2 being oriented in the (001) orientation means that (001) of the crystals constituting the bottom electrode film 2 is parallel or approximately parallel to the main surface of the substrate 1. Also, the crystals constituting the bottom electrode film 2 being preferentially oriented in the (001) orientation means that most of the crystals have (001) parallel or approximately parallel to the main surface of the substrate 1. The bottom electrode film 2 may be a single layer film formed using any of the above metals, alloys mainly composed of any of the above metals, or metal oxides, etc. The bottom electrode film 2 may be a stack of a Pt film and a film mainly composed of SRO provided on the Pt film, or a stack of the Pt film and a film mainly composed of LNO provided on the Pt film, or the like. The thickness of the bottom electrode film 2 (when the bottom electrode film 2 is a stack, the total thickness of each layer) may be, for example, 100 nm or more and 400 nm or less.

A bottom adhesive layer 6 may be provided between the substrate 1 and the bottom electrode film 2 in order to improve adhesion therebetween. The bottom adhesive layer 6 can be, for example, a layer mainly composed of zinc (Zn) and oxygen (O) (hereinafter also referred to as a "ZnO layer"). The ZnO layer can be formed using, for example, zinc oxide. The composition ratio of Zn and O constituting the ZnO layer preferably satisfies a relationship Zn : O = 1 : 1, but is not limited thereto and may vary to some extent. The ZnO layer is a polycrystalline layer. It is preferable that (0001) of the ZnO layer is parallel to the main surface of the substrate 1 (including a case where (0001) is inclined at an angle of $\pm 5°$ or less with respect to the main surface of the substrate 1), that is, the ZnO layer is oriented in the (0001) orientation. The ZnO layer being oriented in the (0001) orientation means that in the X-ray diffraction pattern obtained by XRD measurement on the surface of the piezoelectric film 3, peak intensity caused by (0002) is high. Thus, the main surface of the ZnO layer (the surface serving as the base for the bottom electrode film 2) is preferably composed of ZnO(0001). The ZnO layer can be deposited by a technique such as a sputtering method, a vapor deposition method, etc. The thickness of the ZnO layer may be, for example, 1 nm or more and 200 nm or less, preferably 10 nm or more and 50 nm or less. The bottom adhesive layer 6 may be a layer mainly composed of, for example, titanium (Ti), tantalum (Ta), titanium oxide ($TiO_2$), nickel (Ni), ruthenium oxide ($RuO_2$), iridium oxide ($IrO_2$), etc. Such a bottom adhesive layer 6 can also be deposited by a technique such as a sputtering method or a vapor deposition method, and the thickness of the bottom adhesive layer 6 may be, for example, 1 nm or more and 200 nm or less, preferably 10 nm or more and 50 nm or less.

The piezoelectric film 3 is deposited on the bottom electrode film 2. The piezoelectric film 3 is composed of a perovskite-type oxide represented by a general formula $ABO_3$, with A site containing potassium (K) and sodium (Na) and B site containing niobium (Nb). That is, the piezoelectric film 3 may be a film mainly composed of an alkali niobium oxide containing K, Na, Nb, and oxygen (O) and having a perovskite-type crystal structure. The piezoelectric film 3 can be formed using an alkali niobium oxide represented by a composition formula $(K_{1-x}Na_x)NbO_3$, that is, using potassium sodium niobate (KNN). The coefficient x [=Na/(K+Na)] in the above composition formula can be within a range of $0 < x < 1$, preferably $0.4 \leq x \leq 0.8$. The piezoelectric film 3 is a KNN polycrystalline film (hereinafter also referred to as a KNN film 3).

Further, the alkali niobium oxide constituting the KNN film 3 may further contain at least one element (dopant) selected from the group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). The concentration of these elements in the alkali niobium oxide may be, for example, 5 at% or less (when a plurality of the above elements is contained, the total concentration is 5 at% or less).

The crystals constituting the KNN film 3 are preferentially oriented in the (001) orientation with respect to the main surface of the substrate 1 (Si substrate 1a when the substrate 1 is, for example, the Si substrate 1a having a surface oxide film 1b or an insulating film, etc.). That is, the main surface of the KNN film 3 (the surface serving as the base for the top electrode film 4) is mainly composed of KNN(001). For example, by directly depositing the KNN film 3 on the Pt film (bottom electrode film 2) whose main surface is mainly composed of Pt(111), the KNN film 3 whose main surface is mainly composed of KNN(001) is achieved. In this specification, the crystals constituting the KNN film 3 being oriented in the (001) orientation means that (001) of the crystals constituting the KNN film 3 is parallel or approximately parallel to the main surface of the substrate 1. Also, the crystals constituting the KNN film 3 being preferentially oriented in the (001) orientation means that most of the crystals have (001) parallel or approximately parallel to the main surface of the substrate 1. In this specification, the crystal system of KNN is considered to be a tetragonal system. The thickness of the KNN film 3 may be, for example, 0.5 $\mu$m or more and 5 $\mu$m or less, preferably 1 $\mu$m or more and 3 $\mu$m or less.

The KNN film 3 in this embodiment is deposited, for example, by a two-stage sputtering by simultaneously using two types of targets having different compositions, a first target and a second target described below, and by changing the conditions for applying power to each target. Thus, the KNN film 3 in this embodiment has novel features, specifically Feature 1, which will be described below. Also, the KNN film 3 in this embodiment may further have at least one of Features 2 to 6 described below.

The crystals constituting the KNN film 3 obtained by sputtering include crystals having a columnar structure. It is preferable that half or more of the crystals constituting the KNN film 3 have the columnar structure. Further, it is preferable that the boundaries between the crystals constituting the KNN film 3, that is, crystal grain boundaries present in the KNN film 3, run through the KNN film 3 in a film thickness direction. For example, in the KNN film 3, it is preferable that the number of grain boundaries that run through the KNN film 3 in the film thickness direction is greater than the number of grain boundaries that do not run through the KNN film 3 in the film thickness direction (for example, crystal grain boundaries that are parallel to a surface direction of the main surface of the substrate 1 (the direction along the main surface of the substrate 1)).

The top electrode film 4 is deposited on the KNN film 3. The top electrode film 4 is mainly composed of various metals such as Pt, Au, Al, Cu, etc., or alloys of these metals. The top electrode film 4 can be deposited by a technique such as a sputtering method, a vapor deposition method, a plating method, a metal paste method, etc. The top electrode film 4 does not have a large effect on the crystal structure of the KNN film 3, unlike the bottom electrode film 2. Therefore, a material, a crystal structure, and a deposition method for the top electrode film 4 are not particularly limited. In order to improve adhesion between the KNN film 3 and the top electrode film 4, the top adhesive layer 7 is provided between them. The top adhesive layer 7 can be formed using a metal oxide such as $RuO_2$, $IrO_2$, $TiO_2$, SRO, or LNO. The thickness of the top electrode film 4 may be, for example, 50 nm or more and 5000 nm or less, preferably 50 nm or more and 300 nm or less, and the thickness of the top adhesive layer 7 may be, for example, 1 nm or more and 200 nm or less, preferably 5 nm or more and 50 nm or less.

The following describes Feature 1 that the KNN film 3 of this embodiment has, and Features 2 to 6 that the KNN film 3 of this embodiment may have.

(Feature 1)

The KNN film 3 has a feature (Feature 1) that "when the KNN film 3 is divided into a surface layer region and a bulk region, the total atomic concentration of K and Na in the surface layer region is higher than the total atomic concentration of K and Na in the bulk region."

Here, the "surface layer region" is a region of the KNN film 3 extending from the upper surface of the KNN film 3 to a predetermined depth (e.g., a depth of 3 nm) toward the substrate 1. The "bulk region" is a region of the KNN film 3 other than the surface layer region of the KNN film 3.

In this specification, the "upper surface of the KNN film 3" means one of the two main surfaces of the KNN film 3 that is located on the top electrode film 4 side, that is, the surface that is located opposite to the substrate 1.

In this specification, the "total atomic concentration of K and Na in the surface layer region" is the ratio of the total number of K and Na atoms in the surface layer region with respect to the total number of atoms in the KNN film 3 that constitutes the surface layer region, and is expressed as atomic % (at%). That is, in this specification, the "total atomic concentration of K and Na in the surface layer region" is a value calculated using the following (Equation 1).

Total atomic concentration (at%) of K and Na in the surface layer region = (total number of K and Na atoms in the surface layer region / total number of atoms in the KNN film that constitutes the surface layer region) $\times$ 100     (Equation 1)

In the above (Equation 1), the "total number of K and Na atoms in the surface layer region" is the total number of atoms of K and Na elements contained in the KNN film 3 constituting the surface layer region, and the "total number of atoms in the KNN film constituting the surface layer region" is the total number of atoms of K, Na, Nb, and O elements contained in the KNN film 3 constituting the surface layer region. The "KNN film 3 constituting the surface layer region" is the KNN film 3 deposited in a second deposition step described below, and hereinafter is also referred to as a KNN film 3a.

In this specification, the "total atomic concentration of K and Na in the bulk region" is the ratio of the total number of K and Na atoms in the bulk region with respect to the total number of atoms in the KNN film constituting the bulk region, and is expressed as at%. That is, in this specification, the "total atomic concentration of K and Na in the bulk region" is a value calculated using the following (Equation 2).

Total atomic concentration (at%) of K and Na in the bulk region = (total number of K and Na atoms in the bulk region / total number of atoms in the KNN film that constitutes the bulk region) × 100    (Equation 2)

In the above (Equation 2), the "total number of K and Na atoms in the bulk region" is the total number of atoms of K and Na elements contained in the KNN film 3 constituting the bulk region, and the "total number of atoms in the KNN film constituting the bulk region" is the total number of atoms of K, Na, Nb, and O elements contained in the KNN film 3 constituting the bulk region. The "KNN film 3 constituting the bulk region" is the KNN film 3 deposited in a first deposition step described below, and hereinafter is also referred to as a KNN film 3b.

The total number of K and Na atoms in each of the surface layer region and the bulk region, the total number of atoms in the KNN film 3a, and the total number of atoms in the KNN film 3b can each be measured, for example, by time-of-flight secondary ion mass spectrometry (TOF-SIMS). Measurements using TOF-SIMS can be performed, for example, using a TOF SIMS5 manufactured by ION-TOF.

When calculating the total atomic concentration of K and Na in each of the surface layer region and the bulk region using values measured by TOF-SIMS, measurements are performed by TOF-SIMS at multiple locations throughout the surface layer region and the bulk region, and an average value of the measurement results is used for calculation. In this case, it can be said that the total atomic concentration of K and Na in each of the surface layer region and the bulk region is the average value of the total atomic concentrations of K and Na in each of the surface layer region and the bulk region. The same applies to the total atomic concentration of K and Na in the lower layer region of the bulk region, which will be described later.

In the measurement using TOF-SIMS, it is difficult to accurately measure the number of atoms of O element contained in the KNN film 3 (O atomic concentration in the KNN film 3). However, it is known that in perovskite-type oxide crystals represented by the general formula $ABO_3$, O atom concentration is approximately 60 %. Accordingly, in this embodiment, on the assumption that the O atomic concentration in the KNN film 3 (KNN film 3a, KNN film 3b) is exactly 60 %, the total number of atoms, the total number of atoms in the KNN film 3a, and the total number of atoms in the KNN film 3b are calculated using the results of the composition measurement using TOF-SIMS. The same applies to the calculation of the total number of K and Na atoms in a measurement length of 10 nm, the total number of atoms in a measurement length of 10 nm, the total number of K and Na atoms in the lower layer region, and the total number of atoms in the KNN film 3 that constitutes the lower layer region, which will be described later.

It can be also considered to measure the composition of the surface layer region and the bulk region by Auger electron spectroscopy (AES) or X-ray photoelectron spectroscopy (XPS). That is, it can be also considered to measure a composition distribution in a depth direction (film thickness direction) of the KNN film 3 using AES or XPS, thereby measuring the composition of the surface layer region and the composition of the bulk region. However, in the technique using AES or XPS, the analytical sensitivity of the surface layer region is particularly low, making it difficult to accurately measure the number of K, Na, and Nb atoms in the surface layer region. It can be also considered to measure the composition of the surface layer region and the bulk region by energy dispersive X-ray spectroscopy (EDS), X-ray fluorescence spectroscopy (XRF), or inductively coupled plasma atomic emission spectroscopy (ICP-AES). However, in the technique using these, the sensitivity for analyzing K and Na is low, and therefore the number of K, Na, and Nb atoms in each of the surface layer region and the bulk region cannot be measured accurately in some cases. For these reasons, when calculating the total atomic concentration of K and Na in each of the surface layer region and the bulk region, it is not preferable to use a composition (total atomic number) measured by AES, XPS, EDS, XRF, or ICP-AES.

Due to the KNN film 3 having Feature 1, the DC stress life (DC stress resistance) of the KNN film 3 in the high temperature and high humidity environment can be improved. For example, when a DC stress life measurement test described in the examples below is performed in an atmospheric environment at 85 °C and humidity of 85 %, the time from the start of voltage application until the KNN film 3 undergoes dielectric breakdown can be extended to, for example, more than 1000 hours. In this specification, when the leakage current flowing through the KNN film 3 exceeds 30 mA/cm$^2$, it is considered that the KNN film 3 has undergone a dielectric breakdown. Also, in this specification, in the DC stress life measurement test described in the examples below, the time from the start of voltage application until the KNN film 3 undergoes dielectric breakdown is also referred to as a "DC stress life."

The fact that the composition of the surface layer region (KNN film 3a) of the KNN film 3 affects the DC stress life of the KNN film 3 in the high temperature and high humidity environment, is a new finding that was first found as a result of extensive investigations by the present inventors. That is, the fact that the DC stress life of the KNN film 3 in the high temperature and high humidity environment can be improved by making the total atomic concentration of K and Na in the surface layer region higher than the total atomic concentration of K and Na in the bulk region is a novel finding found for the first time as a result of extensive investigations by the present inventors. Due to improvement of the DC stress life of the KNN film 3 in the high temperature and high humidity environment, the reliability and versatility of the piezoelectric element 20 (piezoelectric device module 30) described below obtained by processing the piezoelectric stack 10, can be improved.

(Feature 2)

The KNN film 3 may further have a feature (Feature 2) that "the difference between a total atomic concentration of K and Na in the surface layer region and a total atomic concentration of K and Na in the bulk region is 1 at% or more and 21 at% or less." That is, the KNN film 3 may further have a feature that "the total atomic concentration of K and Na in the surface layer region is higher than the total atomic concentration of K and Na in the bulk region by, for example, 1 at% or more and 21 at% or less."

This can reliably improve the DC stress life of the KNN film 3 in the high temperature and high humidity environment.

Even when the total atomic concentration of K and Na in the surface layer region is higher than the total atomic concentration of K and Na in the bulk region, due to less than 1 at% of the difference between a total atomic concentration of K and Na in the surface layer region and a total atomic concentration of K and Na in the bulk region, the effect of improving the DC stress life of the KNN film 3 in the above-described high temperature and high humidity environment cannot be sufficiently obtained in some cases.

Due to 1 at% or more of the difference between the total atomic concentration of K and Na in the surface layer region and the total atomic concentration of K and Na in the bulk region, the DC stress life of the KNN film 3 in the above-described high temperature and high humidity environment can be reliably improved.

Even when the total atomic concentration of K and Na in the surface layer region is higher than the total atomic concentration of K and Na in the bulk region, due to beyond 21 at% of the difference between the total atomic concentration of K and Na in the surface layer region and the total atomic concentration of K and Na in the bulk region (i.e., when the total atomic concentration of K and Na in the surface layer region is higher than the total atomic concentration of K and Na in the bulk region by more than 21 at%), the total atomic concentration of K and Na in the surface layer region is likely to be 45 at% or more. When the total atomic concentration of K and Na in the surface layer region is 45 at% or more, the KNN crystals constituting the KNN film 3a cannot maintain the perovskite-type crystal structure in some cases (the KNN film 3a may not have a perovskite-type crystal structure), resulting in causing a high possibility that a different crystalline phase and an amorphous substance will be mixed in the KNN film 3a. When the proportion of the different crystalline phase and amorphous substance in the KNN film 3a increases, the DC stress life of the KNN film 3 is decreased in the high temperature and high humidity environment, or an appropriate potential barrier cannot be formed at an interface between the KNN film 3 and the top electrode film 4 (top adhesive layer 7), resulting in a decrease in the dielectric strength of the KNN film 3.

Due to 21 at% or less of the difference between the total atomic concentration of K and Na in the surface layer region and the total atomic concentration of K and Na in the bulk region, even when the total atomic concentration of K and Na in the surface layer region is higher than the total atomic concentration of K and Na in the bulk region, the decrease in the dielectric strength of the KNN film 3 can be suppressed while reliably obtaining the effect of improving the DC stress life of the KNN film 3 in the above-described high temperature and high humidity environment.

(Feature 3)

The KNN film 3 may further have a feature (Feature 3) that "the total atomic concentration of K and Na in the surface layer region is less than 45 at%."

This allows to reliably improve the DC stress life of the KNN film 3 in the high temperature and high humidity environment. For example, the DC stress life in the high temperature and high humidity environment can be reliably extended to more than 1000 hours. Further, the total atomic concentration of K and Na in the surface layer region is more preferably, for example, 40 % or less. This allows to more reliably improve the DC stress life of the KNN film 3 in the high temperature and high humidity environment. For example, the DC stress life can be more reliably extended to more than 1000 hours.

When the total atomic concentration of K and Na in the surface layer region is higher than the total atomic concentration of K and Na in the bulk region, but when the total atomic concentration of K and Na in the surface layer region is 45 at% or more, as described above, the KNN crystals constituting the KNN film 3a cannot maintain the perovskite-type crystal structure, and the KNN film 3a may have a high proportion of the different crystalline phase or amorphous substances in some cases. As a result, as described above, the DC stress life of the KNN film 3 in the high temperature and high humidity environment may decrease and the dielectric strength of the KNN film 3 may decrease in some cases.

The lower limit of the total atomic concentration of K and Na in the surface layer region is not particularly limited as long as it is higher than the total atomic concentration of K and Na in the bulk region. The total atomic concentration of K and Na in the bulk region is not particularly limited, but may be, for example, 18 at% or more and 22 at% or less.

(Feature 4)

The KNN film further has a feature that "in the KNN film 3 (KNN film 3b) constituting the bulk region, at a position including the center of the surface of the KNN film 3b parallel to the direction along the main surface of the substrate 1 (surface direction of the substrate 1), the difference (deviation) between the total atomic concentration of K and Na when the measurement length is 10 nm in the film thickness direction and the total atomic concentration of K and Na in the bulk region is within 5 % at any position in the film thickness direction of the KNN film 3b excluding each interface region on the upper and lower sides." That is, the KNN film 3 may further have a feature that "the composition of the KNN film 3b is almost uniform in the film thickness direction."

Here, the "interface region on the upper surface side of the KNN film 3b" means a region extending from the interface with the KNN film 3a toward the substrate 1 side to a distance of 0.1 % of the thickness of the KNN film 3b. Further, the "interface region on the lower surface side of the KNN film 3b" means a region extending from the interface with the bottom electrode film 2 toward the top electrode film 4 side to a distance of 0.1 % of the thickness of the KNN film 3b.

In this specification, "at a position including the center of the surface of the KNN film 3b parallel to the surface direction of the substrate 1, the total atomic concentration of K and Na when the measurement length is 10 nm in the film thickness direction" is also simply referred to as a "total atomic concentration of K and Na in the measurement length of 10 nm."

In this specification, the "total atomic concentration of K and Na in the measurement length of 10 nm" is the ratio of the total number of K and Na atoms in the measurement length of 10 nm with respect to the total number of atoms in the measurement length of 10 nm, and is expressed as atomic %. That is, in this specification, the "total atomic concentration of K and Na in the measurement length of 10 nm" is a value calculated using the following (Equation 3).

Total atomic concentration (at%) of K and Na in the measurement length of 10 nm = (total number of K and Na atoms in the measurement length of 10 nm / total number of atoms in the measurement length of 10 nm) × 100　　　(Equation 3)

In the above (Equation 3), the "total number of K and Na atoms in the measurement length of 10 nm" is the total number of atoms of K and Na elements contained in the KNN film 3b at a measurement point in the measurement length of 10 nm. Further, the "total number of atoms in the measurement length of 10 nm" is the total number of atoms of K, Na, Nb, and O elements contained in the KNN film 3b at a measurement point in the measurement length of 10 nm.

The measurement in the measurement length of 10 nm can be performed using, for example, TOF-SIMS. The Measurement using TOF-SIMS can be performed, for example, using a TOF SIMS5 manufactured by ION-TOF.

Further, in addition to the total atomic concentration of K and Na in the measurement length of 10 nm at a position including the center of the surface of the KNN film 3b parallel to the surface direction of the substrate 1, it is preferable that the deviation between the total atomic concentration of K and Na in the bulk region and the total atomic concentration of K and Na when the measurement length is 10 nm in the film thickness direction of the KNN film 3b, at an arbitrary position except the periphery region of the surface of the KNN film 3b parallel to the surface direction of the substrate 1, is within 5 % at any position in the film thickness direction of the KNN film 3b excluding the interface regions on the upper and lower sides.

Here, the "periphery region of the KNN film 3b" means a region on the surface of the KNN film 3b parallel to the surface direction of the substrate 1, extending from the outer periphery of the KNN film 3b toward the center by 5 mm.

Since the KNN film 3 in this embodiment is deposited by, for example, sputtering, the composition of the KNN film 3b can be prevented from varying in the film thickness direction, compared to when the KNN film 3 is deposited by a chemical solution deposition method (CSD method) such as a sol-gel method. This achieves a small deviation between the total atomic concentration of K and Na when the measurement length in the film thickness direction is set to a short length of 10 nm, and the total atomic concentration of K and Na in the bulk region. As a result, the KNN film 3 in this embodiment has the above Feature 4.

Since the KNN film 3 has Feature 4, i.e., the composition of the bulk region is almost uniform in the film thickness direction, the occurrence of crystal defects due to a composition fluctuation in the film thickness direction can be suppressed, and shortening the life span of DC stress caused by the presence of these crystal defects can be suppressed. In this specification, the "shortening the life span of DC stress" is a phenomenon in which, when a (direct current) voltage is applied to the KNN film 3 through the top electrode film 4 so that an electric field of a predetermined magnitude is generated between the bottom electrode film 2 and the top electrode film 4 (i.e., in the KNN film 3), the time from the start of voltage application until the dielectric breakdown of the KNN film 3 is shortened.

In contrast, when the KNN film is deposited by the CSD method, the composition of the KNN film fluctuates (varies) at a constant period (approximately 50 nm period) depending on the deposition method. Therefore, in the bulk region of the KNN film deposited by the CSD method, the deviation between the total atomic concentration of K and Na when the measurement length is 50 nm in the film thickness direction and the total atomic concentration of K and Na in the bulk region may be within 5 % in some cases. However, in the bulk region of the KNN film deposited by the CSD method, the deviation between the total atomic concentration of K and Na when the measurement length is 10 nm in the film thickness direction and the total atomic concentration of K and Na in the bulk region exceeds 5 % depending on the deposition method. Thus, when the KNN film is deposited by the CSD method, the above Feature 4 cannot be obtained.

(Feature 5)

The KNN film 3 may further have the feature (Feature 5) that "the difference (deviation) between the total atomic concentration of K and Na in the lower layer region of the bulk region and the total atomic concentration of K and Na in the bulk region is within 5 %."

In this specification, the "lower layer region of the bulk region (hereinafter also simply referred to as the "lower layer region")" means a region of the bulk region that extends from the lower surface of the KNN film 3 to a height of 10 nm toward the upper surface of the KNN film 3. That is, the lower layer region is a part of the bulk region. Also, in this specification, the "lower surface of the KNN film 3" means, of the two main surfaces of the KNN film 3, the surface opposite to the upper surface of the KNN film 3 described above, that is, the surface located on the substrate 1 side.

Further, in this specification, the "total atomic concentration of K and Na in the lower layer region" is the ratio of the total number of K and Na atoms in the lower layer region with respect to the total number of atoms in the KNN film 3 constituting the lower layer region, and is expressed as atomic % (at%). That is, in this specification, the "total atomic concentration of K and Na in the lower layer region" is a value calculated using the following (Equation 4).

Total atomic concentration (at%) of K and Na in the lower layer region = (total number of K and Na atoms in the lower layer region / total number of atoms in the KNN film constituting the lower layer region) $\times$ 100     (Equation 4)

In the above (Equation 4), the "total number of K and Na atoms in the lower layer region" is the total number of atoms of K and Na elements contained in the KNN film 3 constituting the lower layer region, and the "total number of atoms in the KNN film constituting the lower layer region" is the total number of atoms of K, Na, Nb, and O elements contained in the KNN film 3 constituting the lower layer region. Hereinafter, the KNN film 3 constituting the lower layer region is also referred to as a KNN film 3b1, and the KNN film 3 constituting the bulk region other than the lower layer region out of the KNN film 3b constituting the bulk region is also referred to as a KNN film 3b2. Thus, the KNN film 3b is a stack of the KNN film 3b1 and KNN film 3b2.

The total number of K and Na atoms in the lower layer region and the total number of atoms in the KNN film 3b1 can each be measured by TOF-SIMS. The measurement using TOF-SIMS can be performed, for example, using a TOF SIMS5 manufactured by ION-TOF.

Since the KNN film 3 in this embodiment is deposited by, for example, sputtering, the diffusion (migration) of alkali metal elements (K element, Na element) in the KNN film 3 into the bottom electrode film 2 is suppressed during the deposition of the KNN film 3. This suppresses a deviation of the composition of the KNN film 3b1 from that of the KNN film 3 (KNN film 3b) constituting the bulk region. As a result, the KNN film 3 in this embodiment may have the above Feature 5. Since the KNN film 3 has the above Feature 5, the KNN film 3 that is highly oriented in the (001) orientation, that is, the KNN film 3 with a high (001) orientation rate, can be reliably obtained. For example, the KNN film 3 having a (001) orientation rate of 70 % or more, preferably 80 % or more, can be reliably obtained.

Here, the (001) orientation rate of the KNN film 3 is the orientation rate of the crystals constituting the KNN film 3 in the (001) orientation. "The (001) orientation rate of the KNN film 3 is 70 % or more" means that 70 % or more of the crystals constituting the KNN film 3 are oriented in the (001) orientation with respect to the main surface of the substrate 1. In this specification, the "orientation rate" is a value calculated from the following (Equation 5) based on the peak intensity of an X-ray diffraction pattern (20/0) obtained by performing an XRD measurement to the KNN film 3.

Orientation rate (%) = {(001) peak intensity / ((001) peak intensity + (110) peak intensity)} $\times$ 100     (Equation 5)

The "(001) peak intensity" in the above (Equation 5) is the intensity of a diffraction peak caused by crystals oriented in the (001) orientation (i.e., crystals whose (001) is parallel to the main surface of the substrate 1) among the crystals constituting the KNN film 3 in the X-ray diffraction pattern obtained by performing an XRD measurement to the KNN film 3, which is the intensity of a peak appearing within a 20 range of 20° to 23°. When multiple peaks appear within the 20 range of 20° to 23°, the intensity is that of the highest peak. Further, the "(110) peak intensity" in the above (Equation 5) is the intensity of a diffraction peak caused by crystals oriented in the (110) orientation (i.e., crystals whose (110) is parallel to the main surface of the substrate 1) among the crystals constituting the KNN film 3 in an X-ray diffraction pattern obtained by performing an XRD measurement to the KNN film 3, which is the intensity of the peak appearing within a 2θ range of 30° to 33°. When the multiple peaks appear within the 2θ range of 30° to 33°, the intensity is that of the highest peak.

In order for the KNN film 3 to have a (001) orientation rate of 70 % or more, the KNN film 3 needs to have a perovskite-type crystal structure. When the KNN film 3 does not have the perovskite-type crystal structure, no peak can be observed in the X-ray diffraction pattern obtained by performing an XRD measurement at least within the 2θ range of 20° to 23°, and as a result, the (001) orientation rate cannot be calculated.

When the KNN film 3 does not have the above Feature 5, that is, when the composition of the KNN film 3b1 deviates from the composition of the KNN film 3 (KNN film 3b) constituting the bulk region, the (001) orientation rate of the KNN film 3 is likely to be low. This is because, in the KNN film 3 deposited by sputtering, the composition of the KNN film 3b1 being deviated means that the composition of the KNN film 3 at the start of deposition is also deviated. The deviation of the composition of the KNN film 3 at the start of deposition can adversely affect the orientation of the crystals constituting the KNN film 3 deposited thereafter (thereon), which can result in a decrease in the (001) orientation rate of the KNN film 3.

When the KNN film 3 is deposited by the CSD method, the alkali metal elements in the KNN film 3 may diffuse into the bottom electrode film 2 in some cases depending on the manufacturing method. As a result, the composition of the KNN film 3b1 will be different from the composition of the KNN film 3b. Thus, when the KNN film 3 is deposited by the CSD method, the above Feature 5 may not be obtained in some cases.

(Feature 6)

The KNN film 3 may further have a feature (Feature 6) that "the piezoelectric constant $e_{31}$ is 8 C/m$^2$ or more."

The "piezoelectric constant $e_{31}$" in this specification is a value measured under conditions such that a negative voltage (e.g., a triangular wave or sine wave voltage) is applied to the top electrode film 4 while the bottom electrode film 2 is grounded so as to generate an electric field of 100 kV/cm between the bottom electrode film 2 and the top electrode film 4 (i.e., in the KNN film 3). The "piezoelectric constant $e_{31}$" can be measured, for example, by a method described in Examples.

In this embodiment, due to deposition of the KNN film 3 by, for example, a method described later, only the total atomic concentration of K and Na in the surface layer region can be high. The proportion of the KNN film 3a (surface layer region) in the KNN film 3 is extremely small. Therefore, since only the atomic concentration of K and Na in the surface layer region is high, adversely affecting the piezoelectric characteristics of the entire KNN film 3, i.e., decrease in the piezoelectric constant can be avoided. As a result, the KNN film 3 may further have the above Feature 6.

The KNN film 3 in this embodiment is deposited by, for example, a method described later. This achieves the KNN film 3 having the above Feature 1, preferably the KNN film 3 having the above Feature 1 and at least one of the above Features 2 to 6, and more preferably the KNN film 3 having all of the above Features 1 to 6.

(2) Methods for manufacturing the piezoelectric stack, piezoelectric element, and piezoelectric device module

A method for manufacturing the above-described piezoelectric stack 10, the piezoelectric element, and the piezoelectric device module will be described.

(Deposition of the bottom adhesive layer and bottom electrode film)

First, the substrate 1 is prepared, and the bottom adhesive layer 6 (e.g., ZnO layer) and the bottom electrode film 2 (e.g., Pt film) are deposited in this order on either of the main surfaces of the substrate 1 by, for example, sputtering. It is acceptable to prepare the substrate 1 whose either of the main surfaces has the bottom adhesive layer 6 and the bottom electrode film 2 deposited in advance.

The conditions for depositing the ZnO layer as the bottom adhesive layer 6 are, for example, as follows. The time for depositing the bottom adhesive layer 6 is appropriately adjusted depending on a target thickness of the bottom adhesive layer 6. Target: ZnO sintered ceramics

Temperature (substrate temperature): 200 °C or more and 700 °C or less, preferably 300 °C or more and 700 °C or less, more preferably 500 °C or more and 700 °C or less Applied power (power density): 2 W/cm$^2$ or more and 6 W/cm$^2$ or less, preferably 3 W/cm$^2$ or more and 5 W/cm$^2$ or less

Atmosphere: mixed gas atmosphere of argon (Ar) gas and oxygen (O$_2$) gas (hereinafter also referred to as "Ar/O$_2$ mixed gas atmosphere")

Ratio of partial pressure of Ar gas to Oz gas (Ar gas partial pressure/O$_2$ gas partial pressure): 5/1 to 30/1, preferably 7/1 to 2 0/1, more preferably 10/1 to 15/1

Atmosphere pressure: 0.1 Pa or more and 0.5 Pa or less, preferably 0.2 Pa or more and 0.4 Pa or less

Thickness: 1 nm or more and 200 nm or less, preferably 10 nm or more and 50 nm or less

In this specification, when a numerical range is expressed, such as "5/1 to 30/1", it means that a lower limit and an upper limit are included in the range. The same applies to other numerical ranges.

The conditions for depositing the Ti layer, etc., as the bottom adhesive layer 6 are, for example, as follows.

Target: Ti plate, etc.
Temperature (substrate temperature): 100 °C or more and 500 °C or less, preferably 200 °C or more and 400 °C or less
Atmosphere: Ar gas atmosphere
Atmosphere pressure: 0.1 Pa or more and 0.5 Pa or less, preferably 0.2 Pa or more and 0.4 Pa or less
Other conditions can be similar to those for providing the ZnO layer.

The conditions for depositing the Pt film as the bottom electrode film 2 are, for example, as follows. The time for depositing the bottom electrode film 2 is appropriately adjusted depending on a target thickness of the bottom electrode film 2.

Target: Pt plate
Temperature (substrate temperature): 200 °C or more and 600 °C or less, preferably 300 °C or more and 500 °C or less
Applied power (power density): 1 $W/cm^2$ or more and 5 $W/cm^2$ or less, preferably 2 $W/cm^2$ or more and 4 $W/cm^2$ or less
Atmosphere: Ar gas atmosphere
Atmosphere pressure: 0.1 Pa or more and 0.5 Pa or less, preferably 0.2 Pa or more and 0.4 Pa or less
Thickness: 100 nm or more and 400 nm or less

(Preparation of a target and deposition of the KNN film)

After the deposition of the bottom adhesive layer 6 and the bottom electrode film 2 is completed, the KNN film 3 is then deposited on the bottom electrode film 2 by a sputtering method such as a RF magnetron sputtering method. The composition of the KNN film 3 can be adjusted, for example, by controlling the composition of a target used during the deposition by sputtering (sputtering deposition).

First, as a target used for sputtering deposition of the KNN film 3, a target composed of a perovskite-type oxide (i.e., KNN) represented by a general formula $ABO_3$, with A site containing K and Na and B site containing Nb, is prepared (preparation of a target).

As the target, a first target, and a second target in which the ratio of the total number of K atoms and Na atoms contained per unit volume with respect to the number of Nb atoms contained per unit volume is smaller than that of the first target are prepared. That is, when the numbers of K, Na, and Nb atoms per unit volume contained in the first target are $K_1$, $Na_1$, and $Nb_1$, respectively, and the numbers of K, Na, and Nb atoms per unit volume contained in the second target are $K_2$, $Na_2$, and $Nb_2$, respectively, the first target and the second target are prepared that satisfy a relationship "$(K_1+Na_1) / Nb_1 > (K_2+Na_2) / Nb_2$". For example, the first target and the second target are prepared that satisfy a relationship "total atomic concentration of K and Na in the first target > total atomic concentration of K and Na in the second target".

The target can be fabricated by mixing $K_2CO_3$ powder, $Na_2CO_3$ powder, $Nb_2O_5$ powder, etc., and sintering the mixture. The composition of the target can be controlled by adjusting the mixing ratio of the $K_2CO_3$ powder, $Na_2CO_3$ powder, $Nb_2O_5$ powder, etc. When depositing the KNN film 3 containing the above-described dopant elements such as Cu and Mn, a target in which Cu powder (or CuO powder), Mn powder (or MnO powder), etc., are mixed in a predetermined ratio in addition to the above-described powders, may be used.

The prepared first and second targets are simultaneously used to deposit the KNN film 3 (deposition of the KNN film).

In the deposition of the KNN film 3, a step of depositing the KNN film 3 (KNN film 3b) constituting the bulk region (first deposition step) and a step of depositing the KNN film 3 (KNN film 3a) constituting the surface layer region (second deposition step) are performed in this order.

Further, in the deposition of the KNN film 3, the power applied to the target in the first deposition step and the power applied to the target in the second deposition step are adjusted so that the total atomic concentration of K and Na in the KNN film 3a deposited in the second deposition step is higher than the total atomic concentration of K and Na in the KNN film 3b deposited in the first deposition step. Specifically, in the first deposition step, the powers applied to the first target and the second target are set to be equal, and in the second deposition step, the power applied to the first target is set to be greater than the power applied to the second target.

In this specification, "the powers applied to the first target and the second target are set to be equal" refers not only to the case where the power applied to the first target and the second target are the same, but also to the case where the power applied to the first target and the power applied to the second target are each within a range of ±20 % of an average value of the power applied to the first target and the power applied to the second target.

<First deposition step>

First, the first deposition step is performed to deposit the KNN film 3b (the KNN film 3 constituting the bulk region).

The conditions in the first deposition step are, for example, as follows. The deposition time is appropriately adjusted depending on a target thickness of the KNN film 3b in the bulk region.

First target: a target with a total atomic concentration of K and Na in a range of 22 at% or more and 45 at% or less

Second target: a target with a total atomic concentration of K and Na in a range of 0 at% or more and 18 at% or less

Power applied to the first target (power density): within a range of 10 $W/cm^2$ or more and 70 $W/cm^2$ or less, and equal power to the power applied to the second target

Power applied to the second target (power density): within a range of 10 $W/cm^2$ or more and 70 $W/cm^2$ or less, and equal power to the power applied to the first target

Temperature (substrate temperature): 500 °C or more and 800 °C or less, preferably 600 °C or more and 700 °C or less

Atmosphere: atmosphere containing at least Ar gas, preferably Ar/$O_2$ mixed gas atmosphere

Atmosphere pressure: 0.03 Pa or more and 0.5 Pa or less, preferably 0.04 Pa or more and 0.4 Pa or less

Ratio of partial pressure of $O_2$ gas to Ar gas ($O_2$ gas partial pressure/Ar gas partial pressure): 0 to 1/20, preferably 0 to 1/30

Deposition rate: 0.5 $\mu$m/h or more and 4 $\mu$m/h or less, preferably 0.5 $\mu$m/h or more and 2 $\mu$m/h or less

Thickness of the KNN film constituting the bulk region: 0.5 $\mu$m or more and 5 $\mu$m or less, preferably 1 $\mu$m or more and 3 $\mu$m or less

"A target having a total atomic concentration of K and Na of 0 at%" means a target that does not contain K or Na, that is, means a $Nb_2O_3$ target. Also, "$O_2$ gas partial pressure/Ar gas partial pressure is 0 (zero)" means a state in which the $O_2$ gas partial pressure is 0, that is, an atmosphere of only Ar gas.

When a predetermined time has elapsed since the start of the first deposition step, the discharge (application of power to both targets) is stopped, and the first deposition step is completed.

<Second deposition step>

Subsequently, the powers applied to the first target and the second target are changed to start the second deposition step in which the KNN film 3a (the KNN film 3 constituting the surface layer region) is deposited. The second deposition step is started immediately before the deposition of the KNN film 3 is completed. The present inventors have confirmed that the length of time during which discharge is stopped when switching from the first deposition step to the second deposition step, i.e., the length of time from the end of the first deposition step to the start of the second deposition step, does not affect the advantage obtained in the present disclosure.

Further, when a predetermined time has elapsed since the start of the first deposition step, the power applied to both targets may be changed gradually or stepwise to start the second deposition step. In this case, the powers applied to the first target and the second target are changed immediately before the deposition of the KNN film 3 is completed.

In the second deposition step, the powers applied to the first target and the second target are changed so that the power applied to the first target is greater than the power applied to the second target.

The conditions in the second deposition step are, for example, as follows. The deposition time is appropriately adjusted so that the thickness of the KNN film 3a in the surface layer region becomes, for example, 3 nm.

Power applied to the first target (power density): within a range of 10 $W/cm^2$ or more and 80 $W/cm^2$ or less, and greater than the power applied to the second target

Power applied to the second target (power density): within a range of 0 $W/cm^2$ or more and 70 $W/cm^2$ or less, and smaller than the power applied to the first target

Other conditions can be similar to those in the first deposition step.

"The power applied to the second target is 0 $W/cm^2$" means that no power is applied to the second target.

Further, in the second deposition step, the power applied to the first target is preferably set to be greater than the power applied to the first target in the first deposition step within the range of the above conditions. This ensures to achieve the KNN film 3 in which the total atomic concentration of K and Na in the surface layer region is higher than the total atomic concentration of K and Na in the bulk region.

Further, in the second deposition step, the power applied to the second target is preferably set to be smaller than the power applied to the second target in the first deposition step within the range of the above conditions. This further ensures to achieve the KNN film 3 in which the total atomic concentration of K and Na in the surface layer region is higher than the total atomic concentration of K and Na in the bulk region.

Thus, the KNN film 3 is deposited in two stages by simultaneously using two types of targets, the first target and the second target, and by changing the power (power density) applied to each target.

Due to deposition of the KNN film 3 under the above-described conditions, the total atomic concentration of K and Na in the surface layer region deposited in the second deposition step can be higher than the total atomic concentration of K and Na in the bulk region deposited in the first deposition step. As a result, the KNN film 3 having the above Feature 1 is achieved.

Further, due to deposition of the KNN film 3 under the above-described conditions, the difference between the total atomic concentration of K and Na in the surface layer region and the total atomic concentration of K and Na in the bulk region can be 1 at% or more and 21 at% or less, while the total atomic concentration of K and Na in the surface layer region is higher than the total atomic concentration of K and Na in the bulk region. As a result, the KNN film 3 may further have the above Feature 2.

Further, due to deposition of the KNN film 3 under the above-described conditions, the total atomic concentration of K and Na in the surface layer region can be, for example, less than 45 at%, while the total atomic concentration of K and Na in the surface layer region is higher than the total atomic concentration of K and Na in the bulk region. As a result, the KNN film 3 may further have the above Feature 3.

Further, due to deposition of the KNN film 3b by performing the first deposition step under the above-described conditions, the composition of the KNN film 3b can be almost uniform in the film thickness direction. That is, due to deposition of the KNN film 3 under the above-described conditions, not only can the total atomic concentration of K and Na in the surface layer region be higher than the total atomic concentration of K and Na in the bulk region, but the composition of the KNN film 3b can also be almost uniform in the film thickness direction. As a result, the KNN film 3 may further have the above Feature 4.

Further, due to deposition of the KNN film 3 under the above-described conditions, not only can the total atomic concentration of K and Na in the surface layer region be higher than the total atomic concentration of K and Na in the bulk region, but also diffusion of the alkali metal elements contained in the KNN film 3 into the bottom electrode film 2 can be suppressed during deposition of the KNN film 3. As a result, the KNN film 3 may further have the above Feature 5.

Further, due to deposition of the KNN film 3 under the above-described conditions, only the total atomic concentration of K and Na in the surface layer region can be increased. This allows to avoid adversely affecting the piezoelectric characteristics of the entire KNN film 3. That is, due to deposition of the KNN film 3 under the above-described conditions, not only can the total atomic concentration of K and Na in the surface layer region be higher than the total atomic concentration of K and Na in the bulk region, but also a decrease in the piezoelectric constant of the KNN film 3 can be avoided. As a result, the KNN film 3 may further have the above Feature 6.

Thus, due to deposition of the KNN film 3 through the first and second deposition steps in this order under the above-described conditions simultaneously using two types of targets having different compositions, the first target and the second target, the KNN film 3 having the above Feature 1, preferably the KNN film 3 having the above Feature 1 and at least one of the above Features 2 to 6, and more preferably the KNN film 3 having all of the above Features 1 to 6, is achieved.

(Deposition of the top adhesive layer and top electrode film)

After deposition of the KNN film 3 is completed, the top adhesive layer 7 (e.g., $RuO_2$ layer) and the top electrode film 4 (e.g., Pt film) are deposited in this order on the KNN film 3 by, for example, a sputtering method.

The conditions for depositing the $RuO_2$ layer, etc., as the top adhesive layer 7 are, for example, as follows. The time for depositing the top adhesive layer 7 is appropriately adjusted depending on a target thickness of the top adhesive layer 7.

Target: Ru plate, etc.
Temperature (substrate temperature): room temperature (25 °C) or more and 500 °C or less
Applied power (power density): 0.3 $W/cm^2$ or more and 2 $W/cm^2$ or less, preferably 0.5 $W/cm^2$ or more and 1 $W/cm^2$ or less
Atmosphere: $Ar/O_2$ mixed gas atmosphere
Ratio of Ar gas partial pressure to $O_2$ gas (Ar gas partial pressure/$O_2$ gas partial pressure): 3/5 to 1/1, preferably 3/4 to 1/1
Atmosphere pressure: 0.1 Pa or more and 1.0 Pa or less, preferably 0.2 Pa or more and 0.7 Pa or less
Thickness: 1 nm or more and 200 nm, preferably 5 nm or more and 50 nm or less

The conditions for depositing the Pt film, etc., as the top electrode film 4 are, for example, as follows. The time for depositing the top electrode film 4 is appropriately adjusted depending on a target thickness of the top electrode film 4.

Target: Pt plate, etc.
Temperature (substrate temperature): room temperature (25 °C) or more and 500 °C or less
Applied power (power density): 1 $W/cm^2$ or more and 5 $W/cm^2$ or less, preferably 2 $W/cm^2$ or more and 4 $W/cm^2$ or less
Atmosphere: Ar gas atmosphere
Atmosphere pressure: 0.1 Pa or more and 0.5 Pa or less, preferably 0.2 Pa or more and 0.4 Pa or less
Thickness: 50 nm or more and 5000 nm or less, preferably 50 nm or more and 300 nm or less

As described above, the bottom adhesive layer 6, the bottom electrode film 2, the KNN film 3 (KNN film 3b, KNN film 3a), the top adhesive layer 7, and the top electrode film 4 are deposited in this order to obtain the piezoelectric stack 10 as illustrated in FIG. 1.

(Fabrication of the piezoelectric element)

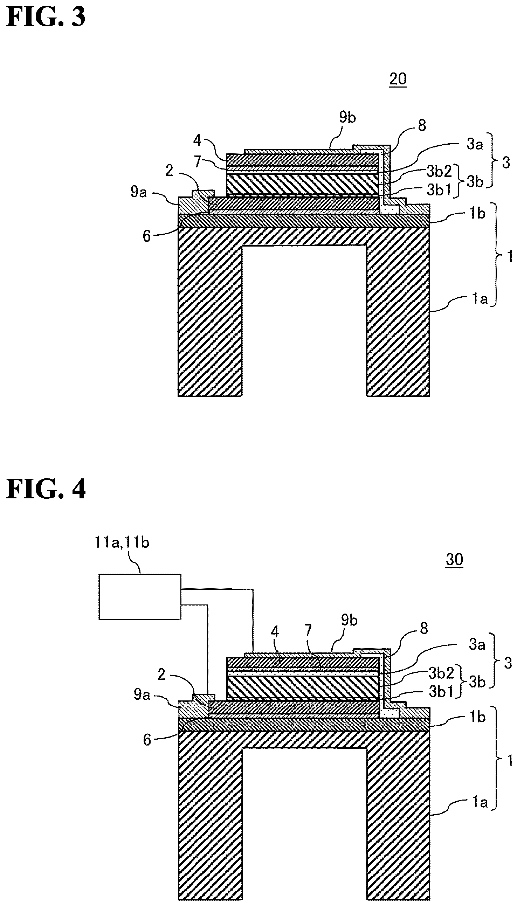

After the piezoelectric stack 10 as illustrated in FIG. 1 is fabricated, the piezoelectric stack 10 is processed to form an element having the KNN film 3 (also referred to as a piezoelectric element 20).
Specifically, first, for example, the top electrode film 4 (including the top adhesive layer 7) and the KNN film 3 are individually patterned by dry etching using Ar gas or a reactive gas. In the patterning, the top electrode film 4 (including the top adhesive layer 7) and the KNN film 3 are each formed into a predetermined shape, and a part of the bottom electrode film 2 is exposed. Also, in the patterning, a photoresist can be used as an etching mask. FIG. 2 illustrates the piezoelectric stack 10 after patterning is completed, that is, illustrates the piezoelectric element 20. The piezoelectric element 20 illustrated in FIG. 2 is also referred to as a simple piezoelectric element.
After fabricating the simple piezoelectric element as illustrated in FIG. 2, for example, the bottom electrode film 2 and the bottom adhesive layer 6 are patterned by dry etching using Ar gas or a reactive gas, and the bottom electrode film 2 and the bottom adhesive layer 6 are each formed into predetermined shapes. In this patterning, a photoresist can be used as an etching mask.
After patterning of the bottom electrode film 2 and the bottom adhesive layer 6 is completed, an insulating film 8 and metal wirings 9a and 9b are provided. Specifically, first, a layer composed of an insulating material is provided from the top electrode film 4 to the substrate 1 so as to cover the side surface of the KNN film 3, and the layer composed of the insulating material is patterned by dry etching using the reactive gas such as Ar gas or $CF_4$ gas, or wet etching, to provide an insulating film 8. The insulating film 8 can be formed using an oxide such as silicon oxide ($SiO_2$), aluminum oxide ($Al_2O_3$), or tantalum oxide ($Ta_2O_5$). The insulating film 8 may be a single layer film or a stack having multiple layers stacked on top of each other. The insulating film 8 can be provided by a method such as a CVD method or a sputtering method.
After the insulating film 8 is provided, a layer composed of a material containing metal (metal wiring layer) is provided. Then, the metal wiring layer is patterned by dry etching using Ar gas or a reactive gas, or wet etching, to form metal wirings 9a and 9b. The metal wiring 9a is formed (patterned) so as to be connected (in contact) with the bottom electrode film 2 but not connected (in contact) with the top electrode film 4, and the metal wiring 9b is formed so as to be connected to the top electrode film 4 but not connected to the bottom electrode film 2. The metal wirings 9a and 9b can be formed using various metals such as Au, Al, Ti, Cr, etc., or an alloy mainly composed of these metals. The metal wirings 9a and 9b may be a single layer film or a stack having multiple layers stacked on top of each other. The metal wirings 9a and 9b (metal wiring layers) can be provided by a method such as a sputtering method, a vapor deposition method, a plating method, a metal paste method, etc.
Further, a part of the substrate 1 is removed from the back surface side of the substrate 1 (one of the two main surfaces of the substrate 1 opposite to the surface on which the bottom electrode film 2, etc., is deposited) by Deep-RIE or wet etching. This achieves the piezoelectric element 20 having a membrane structure, a cantilever structure, etc., for example, a membrane-type MEMS piezoelectric element 20 as illustrated in FIG. 3.
The etching conditions for patterning when forming the insulating film 8 and the metal wirings 9a, 9b, and the etching conditions for the substrate 1 when processing the piezoelectric stack 10 into the piezoelectric element 20 can be general etching conditions used in a semiconductor device manufacturing process, so long as the conditions do not deteriorate the insulating properties of the KNN film 3.

(Fabrication of the piezoelectric device module)

By connecting a voltage detection unit 11a or a voltage application unit 11b to the obtained piezoelectric element 20, a device module 30 (hereinafter also referred to as a piezoelectric device module 30) is obtained having the KNN film 3. FIG. 4 illustrates a schematic configuration view of the piezoelectric device module 30 according to this embodiment. The piezoelectric device module 30 includes at least the piezoelectric element 20 and the voltage detection unit 11a or the voltage application unit 11b connected to the piezoelectric element 20. The voltage detection unit 11a detects a voltage generated between the bottom electrode film 2 and the top electrode film 4 (between the electrodes). The voltage application unit 11b applies a voltage between the bottom electrode film 2 and the top electrode film 4 (between the electrodes). As the voltage detection unit 11a and the voltage application unit 11b, various known units can be used.

By connecting the voltage detection unit 11a between the bottom electrode film 2 and the top electrode film 4 of the piezoelectric element 20, the piezoelectric device module 30 can function as a sensor. When the KNN film 3 is deformed in accordance with a change in some physical quantity, a voltage is generated between the bottom electrode film 2 and the top electrode film 4 due to the deformation. By detecting this voltage with the voltage detection unit 11a, the magnitude of the physical quantity applied to the KNN film 3 can be measured. In this case, examples of applications of the piezoelectric device module 30 include an angular velocity sensor, an ultrasonic sensor, a pressure sensor, and an acceleration sensor.

By connecting the voltage application unit 11b between the bottom electrode film 2 and the top electrode film 4 of the piezoelectric element 20, the piezoelectric device module 30 can function as an actuator. By applying a voltage between the bottom electrode film 2 and the top electrode film 4 with the voltage application unit 11b, the KNN film 3 can be deformed. This deformation action can actuate various structures connected to the piezoelectric device module 30. In this case, examples of applications of the piezoelectric device module 30 include a head for an inkjet printer, a MEMS mirror for an optical scanner, and a vibrator for an ultrasonic generator.

(3) Effect

According to this embodiment, one or more of the following effects can be obtained.

(a) In the KNN film 3, due to the higher total atomic concentration of K and Na in the surface layer region than the total atomic concentration of K and Na in the bulk region, the DC stress life of the KNN film 3 in the high temperature and high humidity environment can be improved. For example, in a DC stress life measurement test described in the Examples below, the time until the KNN film 3 undergoes dielectric breakdown can be extended to more than 1000 hours. As a result, the piezoelectric element 20 (piezoelectric device module 30) obtained by processing the piezoelectric stack 10 can operate normally for a long period of time (long hours) even in the high temperature and high humidity environment. That is, the reliability of the piezoelectric element 20 (piezoelectric device module 30) when used in the high temperature and high humidity environment can be improved. Further, the versatility of the piezoelectric element 20 (piezoelectric device module 30) can be improved.

(b) Due to the higher total atomic concentration of K and Na in the surface layer region than the total atomic concentration of K and Na in the bulk region by, for example, 1 at% or more and 21 at% or less, the effect of improving the DC stress life of the KNN film 3 in the high temperature and high humidity environment can be reliably obtained.

(c) Since the total atomic concentration of K and Na in the surface layer region is, for example, less than 45 at%, the effect of improving the DC stress life of the KNN film 3 in the high temperature and high humidity environment can be more reliably obtained.

(d) Since not only is the total atomic concentration of K and Na in the surface layer region higher than the total atomic concentration of K and Na in the bulk region but also the composition of the KNN film 3b in the thickness direction is almost uniform, therefore the occurrence of crystal defects caused by composition fluctuation in the KNN film 3 in the film thickness direction can be suppressed. As a result, the shortening the life span of DC stress caused by the presence of these crystal defects can be suppressed.

(e) Due to the deviation between the total atomic concentration of K and Na in the lower layer region and the total atomic concentration of K and Na in the bulk region within 5 %, the KNN film 3 highly oriented in the (001) orientation is reliably achieved.

(f) Since only the total atomic concentration of K and Na in the surface layer region is high, a decrease in the piezoelectric constant of the entire KNN film 3 can be avoided. That is, even when the total atomic concentration of K and Na in the surface layer region is higher than the total atomic concentration of K and Na in the bulk region, the piezoelectric constant $e_{31}$ of the KNN film 3 can be 8 C/m$^2$ or more. Thus, in this embodiment, the DC stress life of the KNN film 3 in the high temperature and high humidity environment can be improved without decreasing the piezoelectric constant of the KNN film 3.

(4) Modified examples

This embodiment can be modified as follows. In the following description of the modified example, the same components as those in the above embodiment are given the same reference numerals, and the description thereof will be omitted. Further, the above embodiments and the following modified examples can be combined in any manner.

(Modified example 1)

The above embodiment shows an example in which the piezoelectric stack 10 includes the bottom electrode film 2, but the present disclosure is not limited thereto. The piezoelectric stack 10 does not necessarily need to include the bottom electrode film 2. That is, the piezoelectric stack 10 may be configured to include the substrate 1, the KNN film (piezoelectric film) 3 on the substrate 1, the top adhesive layer 7 on the KNN film 3, and the top electrode film 4 (electrode film 4) on the top adhesive layer 7. The bottom adhesive layer 6 may be provided between the substrate 1 and the KNN film 3. When a predetermined level of adhesion can be ensured, the bottom adhesive layer 6 or the top adhesive layer 7 may be omitted. The piezoelectric stack 10 of this modified example, and ultimately the piezoelectric element 20 (piezoelectric device module 30) obtained by processing the piezoelectric stack 10 of this modified example, can function as a filter device such as a surface acoustic wave (SAW) filter.

In this modified example as well, for example, due to deposition of the KNN film 3 by simultaneously using two types of targets, the first target and the second target, and performing the first deposition step and the second deposition step in this order under similar conditions to those described in the above embodiment, the KNN film 3 having the above Feature 1, preferably the KNN film 3 having the above Feature 1 and at least one of the above Features 2 to 6, and more preferably the KNN film 3 having all of the above Features 1 to 6, is achieved. As a result, in this modified example as well, the same effects as those in the above embodiment can be obtained.

(Modified example 2)

The above embodiment shows an example in which the KNN film 3 is a KNN polycrystalline film, but the present disclosure is not limited thereto. The piezoelectric film 3 may be a single crystal film (epitaxial film) of perovskite-type alkali niobium oxide (KNN) containing K, Na, Nb, and O. Hereinafter, the KNN single crystal film is also referred to as an epi-KNN film 3. The crystals constituting the epi-KNN film 3 preferably have a (001) orientation with respect to the surface of the substrate 1.

In this modified example, a single crystal Si substrate 1a, etc., similar to that in the above embodiment can be used as the substrate 1. Alternatively, a substrate composed of single crystal strontium titanium oxide ($SrTiO_3$), single crystal magnesium oxide (MgO), or single crystal fluorite (calcium fluoride, $CaF_2$) can be used as the substrate 1.

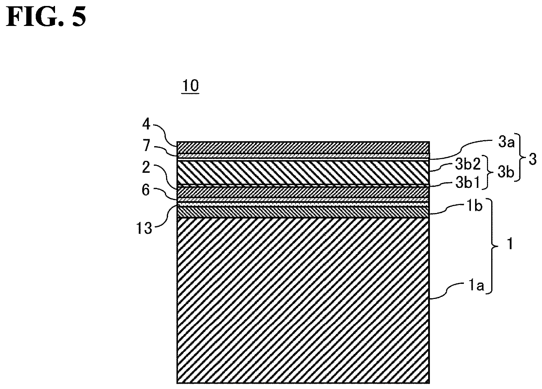

As illustrated in FIG. 5, in this modified example, a buffer layer 13 is provided between the substrate 1 and the bottom electrode film 2 (or the bottom adhesive layer 6 when the bottom adhesive layer 6 is provided). The buffer layer 13 can be formed using, for example, zirconia stabilized with yttrium (Y) oxide ($Y_2O_3$) (composition formula: $(ZrO_2)_{1-x}(Y_2O_3)_x$, abbreviated as YSZ). The composition of the buffer layer 13 is preferably such that the crystal structure of the buffer layer 13 is a cubic crystal (cubic structure, cubic phase). For example, it is preferable that the coefficient x in the composition formula $(ZrO_2)_{1-x}(Y_2O_3)_x$ is within a range of $0.065 \leq x \leq 0.155$. The thickness of the buffer layer 13 may be, for example, 5 nm to 300 nm, preferably 10 nm to 200 nm. By depositing the buffer layer 13 on the substrate 1 by a method such as PLD (Pulsed Laser Deposition) or sputtering, the buffer layer 13 grows epitaxially to become a single crystal epitaxial film.

Then, by depositing the bottom adhesive layer 6 and the bottom electrode film 2 in this order on the buffer layer 13, the bottom electrode film 2 can be epitaxially grown to become a single crystal epitaxial film. Then, by depositing the KNN film 3 on the bottom electrode film 2, the KNN crystal epitaxially grows, and the epi-KNN film 3 is obtained.

The conditions for depositing the YSZ layer as the buffer layer 13 by the PLD method are, for example, as follows. The time for depositing the buffer layer 13 is appropriately adjusted depending on a target thickness of the buffer layer 13.

Substrate temperature: 500 °C or more and 1000 °C or less, preferably 600 °C or more and 800 °C or less
Atmosphere: Atmosphere containing at least oxygen ($O_2$), preferably $O_2$ gas atmosphere
Atmosphere pressure: $5.0 \times 10^{-2}$ Pa or more and $10.0 \times 10^{-2}$ Pa or less, preferably $7 \times 10^{-2}$ Pa or more and $8.0 \times 10^{-2}$ Pa or less
Laser frequency: 5 Hz or more and 10 Hz or less, preferably 6 Hz or more and 8 Hz or less

The conditions for depositing the bottom adhesive layer 6, the bottom electrode film 2, the KNN film 3 (epi-KNN film 3), the top adhesive layer 7, and the top electrode film 4 can be similar to those in the above embodiment.

In this modified example as well, for example, due to deposition of the KNN film 3 by simultaneously using two types of targets, the first target and the second target, and performing the first deposition step and the second deposition step in this order under similar conditions to those described in the above embodiment, the epi-KNN film 3 having the above Feature 1, preferably the epi-KNN film 3 having the above Feature 1 and at least one of the above Features 2 to 6, and more preferably the epi-KNN film 3 having all of the above Features 1 to 6, is achieved. As a result, in this modified example as well, the same effects as those in the above embodiment can be obtained.

(Modified example 3)

The above embodiment shows an example in which the piezoelectric film 3 is composed of a perovskite-type oxide represented by the general formula $ABO_3$, with A site containing K and Na and B site containing Nb, i.e., the piezoelectric film 3 is the KNN film 3, but the present disclosure is not limited thereto. The A site may include at least one element selected from the group consisting of lithium (Li), sodium (Na), potassium (K), lead (Pb), magnesium (Mg), calcium (Ca), strontium (Sr), barium (Ba), lanthanum (La), cadmium (Cd), bismuth (Bi), manganese (Mn), and copper (Cu). The B site may include at least one element selected from the group consisting of titanium (Ti), zirconium (Zr), scandium (Sc), vanadium (V), niobium (Nb), tantalum (Ta), chromium (Cr), molybdenum (Mo), tungsten (W), Mn, iron (Fe), ruthenium (Ru), cobalt (Co), iridium (Ir), nickel (Ni), Cu, zinc (Zn), gallium (Ga), indium (In), tin (Sn), and antimony (Sb). Cu and Mn can be contained in either A site or B site depending on the conditions for depositing the piezoelectric film 3.

In this modified example as well, since the piezoelectric film 3 has the feature (Feature 1) that "the total atomic concentration of the elements contained in A site in the surface layer region is higher than the total atomic concentration of the elements contained in A site in the bulk region", therefore, at least the effect of improving the DC stress life of the piezoelectric film 3 in the high temperature and high humidity environment can be obtained.

<Other embodiment>

One embodiment of the present disclosure has been specifically described above. However, the present disclosure is not limited to the above-described embodiments, and various modifications are possible without departing from the spirit and scope of the present disclosure. In addition, these embodiments can be combined in any manner.

For example, when the above-described piezoelectric stack 10 is formed into the piezoelectric element 20, the substrate 1 in the piezoelectric stack 10 may be replaced with another substrate, as long as the piezoelectric device module 30 fabricated using the piezoelectric stack 10 (piezoelectric element 20) can be applied to a desired purpose such as a sensor or an actuator, etc.

The above embodiment shows an example in which one stack is formed on one substrate 1, but the present disclosure is not limited thereto. For example, multiple stacks may be formed on one substrate 1. In this case, each of the multiple stacks includes (the bottom adhesive layer 6,) the bottom electrode film 2, the KNN film 3, (the top adhesive layer 7,) and the top electrode film 4. The substrate 1 on which one or more stacks are formed is also referred to as a piezoelectric stack substrate.

Examples

Hereinafter, experimental results that support the effect of the above embodiments will be described.

(Fabrication of samples 1 to 21)

A Si substrate was prepared as a substrate, the surface of which had a (100) orientation, having a thickness of 610 $\mu$m and a diameter of 6 inches (also referred to as "$\varphi$6 inches"), and having a thermal oxide film (thickness of 200 nm) formed on the surface. Then, a ZnO layer (thickness of 25 nm) as a bottom adhesive layer, a Pt film (preferentially oriented in the (111) orientation with respect to the surface of the substrate, thickness of 200 nm) as a bottom electrode film, a KNN (polycrystalline) film (thickness of 2 $\mu$m) as a piezoelectric film, a $RuO_2$ layer (thickness of 10 nm) as a top adhesive layer, and a Pt film (thickness of 100 nm) as a top electrode film were deposited on the thermal oxide film of the Si substrate in this order, to fabricate samples 1 to 21, which are piezoelectric stacks. In samples 1 to 21, the bottom adhesive layer, the bottom electrode film, the KNN film, the top adhesive layer, and the top electrode film were all deposited by RF magnetron sputtering under the conditions shown below. In samples 1 to 21, during deposition of the KNN film, two targets having different compositions were simultaneously used, and the first deposition step and the second deposition step described in the above embodiment were performed.

<Conditions for depositing the ZnO layer as the bottom adhesive layer>

Target: ZnO sintered ceramics
Substrate temperature: 500 °C
Applied power (power density): 4 W/cm$^2$
Atmosphere: Ar/$O_2$ mixed gas atmosphere
Atmosphere pressure: 0.3 Pa

Ar gas partial pressure/O$_2$ gas partial pressure: 10/1
Deposition time: 3 minutes (thickness 25 nm)

<Conditions for depositing the Pt film as the bottom electrode film>

Target: Pt plate
Substrate temperature: 500 °C
Applied power (power density): 2 W/cm$^2$
Atmosphere: Ar gas atmosphere
Atmosphere pressure: 0.3 Pa
Deposition time: 14 minutes (thickness 200 nm)

<Conditions for the first deposition step (conditions for depositing the KNN film constituting the bulk region)>

First target: KNN target with 35 at% or 45 at% total atomic concentration of K and Na
Second target: KNN target with 5 at% or 0 at% total atomic concentration of K and Na
Power (power density) applied to the first target: as shown in Table 1 below
Power (power density) applied to the second target: as shown in Table 1 below
Atmosphere: Ar/O$_2$ mixed gas atmosphere
Atmosphere pressure: 0.1 Pa
O$_2$ gas partial pressure/Ar gas partial pressure: 1/20
Deposition temperature: 600 °C
Deposition time: 60 minutes (target thickness: 2000 nm (2 $\mu$m))

<Conditions for the second deposition step (conditions for depositing the KNN film constituting the surface layer region)>

Target: the same target as used to deposit the KNN film that constitutes the bulk region
Power (power density) applied to the first target: as shown in Table 1 below
Power (power density) applied to the second target: as shown in Table 1 below
Atmosphere: Ar/O$_2$ mixed gas atmosphere
Atmosphere pressure: 0.1 Pa
O$_2$ gas partial pressure/Ar gas partial pressure: 1/20
Deposition temperature: 600 °C
Deposition time: 6 seconds (target thickness: 3 nm)

<Conditions for depositing the RuO$_2$ layer as the top adhesive layer>

Target: Ru plate
Substrate temperature: room temperature (25 °C)
Applied power (power density): 0.5 W/cm$^2$
Atmosphere: Ar/O$_2$ mixed gas atmosphere
Atmosphere pressure: 0.3 Pa
Ar gas partial pressure/O$_2$ gas partial pressure: 1/1
Deposition time: 6 minutes (thickness 10 nm)

<Conditions for depositing the Pt film as the top electrode film>

Target: Pt plate
Substrate temperature: room temperature (25 °C)
Applied power (power density): 2 W/cm$^2$
Atmosphere: Ar gas atmosphere
Atmosphere pressure: 0.3 Pa
Deposition time: 7 minutes (thickness 100 nm)

The powers applied to the first and second targets of samples 1 to 21 are shown in Table 1 below. In Table 1 below, in the samples with (*) next to the sample number, a target having a total atomic concentration of K and Na of 45 at% was used as the first target, and a target having a total atomic concentration of K and Na of 0 at% was used as the second target. Also, in Table 1, in the samples without (*) next to the sample number, a target having a total atomic concentration of K and Na of 35 at% was used as the first target, and a target having a total atomic concentration of K and Na of 5 at% was used as the second target.

[Table 1]

| Sample No. | Applied voltage | | | |
| --- | --- | --- | --- | --- |
| | First deposition step | | Second deposition step | |
| | First target (W/cm$^2$) | Second target (W/cm$^2$) | First target (W/cm$^2$) | Second target (W/cm$^2$) |
| 1 (*) | 44 | 36 | 80 | 0 |
| 2 (*) | 44 | 36 | 70 | 10 |
| 3 | 40 | 40 | 66 | 14 |
| 4 | 40 | 40 | 45 | 35 |
| 5 | 40 | 40 | 40 | 40 |
| 6 | 40 | 40 | 34 | 46 |
| 7 (*) | 41 | 39 | 80 | 0 |
| 8 (*) | 41 | 39 | 70 | 10 |
| 9 | 45 | 35 | 48 | 32 |
| 10 | 45 | 35 | 45 | 35 |
| 11 | 45 | 35 | 40 | 40 |
| 12 (*) | 46 | 34 | 80 | 0 |
| 13 (*) | 46 | 34 | 70 | 10 |
| 14 | 44 | 36 | 42 | 38 |
| 15 | 44 | 36 | 44 | 36 |
| 16 | 44 | 36 | 34 | 46 |
| 17 (*) | 48 | 32 | 80 | 0 |
| 18 (*) | 48 | 32 | 70 | 10 |
| 19 | 46 | 34 | 44 | 36 |
| 20 | 46 | 34 | 46 | 34 |
| 21 | 46 | 34 | 32 | 48 |

<Evaluation 1>

For each of samples 1 to 21, the total atomic concentration of K and Na in the surface layer region and the total atomic concentration of K and Na in the bulk region were measured, and the DC stress life in the high temperature and high humidity environment and the piezoelectric constant $e_{31}$ were evaluated.

(Measurement of the total atomic concentration of K and Na in each of the surface layer region and bulk region)

The total atomic concentrations of K and Na in each region of the surface layer region and the bulk region of samples 1 to 21 were measured using the following equipment, conditions, and method.

Equipment: TOF SIMS5 manufactured by ION-TOF Co. Ltd.
Measurement method: for each sample, TOF-SIMS was used to calculate the total number of K and Na atoms in each of the surface layer region and bulk region, the total number of atoms in the KNN film constituting the surface layer region, and the total number of atoms in the KNN film constituting the bulk region. At this time, the total atomic concentrations of K and Na in each of the surface layer region and the bulk region were calculated using the above (Equation 1) and (Equation 2), on the assumption that the O atomic concentration in the KNN film is exactly 60 %.

(Evaluation of the DC stress life)

The DC stress life of the KNN film was evaluated using the following equipment, conditions, and method.

Equipment: small thermohygrostat (Model: IW223) manufactured by Yamato Scientific Co., Ltd.
Measurement temperature: 85 °C (substrate temperature)
Measurement humidity: 85 %
Measurement atmosphere: Air
Measurement method: first, the stack of each sample was patterned to form the top electrode film and the top adhesive layer into a size of 0.5 mmφ, and part of the bottom electrode film was exposed. Then, Au wires were wire-bonded to each of the top and bottom electrode films, and electrically connected to a voltage application unit.

Thereafter, a voltage was applied to the KNN film via the top electrode film by the voltage application unit so that an electric field of 200 kV/cm was generated between the bottom electrode film and the top electrode film (i.e., in the KNN film), and the stack of each sample was set in a constant temperature and humidity chamber with the voltage applied. Then, the time from the start of voltage application until the KNN film undergoes dielectric breakdown was measured. In this measurement, when the leakage current flowing through the KNN film exceeded 30 mA/cm$^2$, the KNN film was deemed to have undergone dielectric breakdown.

(Piezoelectric constant $e_{31}$)

The piezoelectric constant $e_{31}$ of the KNN film was measured using the following equipment, conditions, and method.

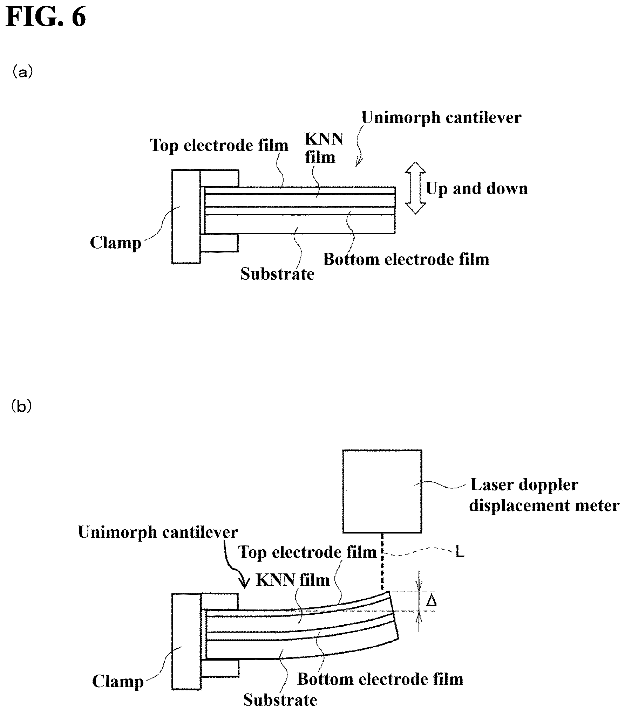

Equipment: Laser Doppler vibrometer (model number: V100) manufactured by Iwasaki Telecommunications Co., Ltd. (IWATSU)
Measurement atmosphere: air
Temperature: room temperature (25 °C)
Measurement method: first, a small rectangular piece measuring 20 mm in length and 2.5 mm in width was cut out from each of samples 1 to 21. Then, as illustrated in FIG. 6 (a), one end in a longitudinal direction of each of the small pieces obtained from samples 1 to 21 was fixed with a clamp, and a voltage application unit (not illustrated) was connected between the bottom electrode film and the top electrode film to fabricate a simple unimorph cantilever. Then, using the voltage application unit, 350 Hz sine wave negative voltage was applied to the KNN film through the top electrode film while the bottom electrode film was grounded, so as to generate an electric field of 100 kV/cm between the bottom electrode film and the top electrode film (i.e., in the KNN film), thereby stretching (deforming) the KNN film. Due to the deformation of the KNN film, an entire cantilever bends and stretches (vibrates), and the tip of the cantilever reciprocates up and down. An amount of displacement Δ of the tip of the cantilever (an amount of piezoelectric displacement) at this time was measured by irradiating the tip of the cantilever with laser light L from a Laser Doppler displacement meter as illustrated in FIG. 6 (b). Then, the piezoelectric constant $e_{31}$ at an applied electric field of 100 kV/cm was calculated using the amount of the displacement Δ of the tip of the cantilever, the length of the cantilever, and the applied voltage.

Table 2 shows the results of these measurements. In Table 2, "+" in the "Difference in total atomic concentration of K and Na" column means that the total atomic concentration of K and Na in the surface layer region is higher than the total atomic concentration of K and Na in the bulk region, and "-" in the column means that the total atomic concentration of K and Na in the surface layer region is lower than the total atomic concentration of K and Na in the bulk region. For example, in Table 2, "+25 at%" in the column means that the total atomic concentration of K and Na in the surface layer region is 25 at% higher than the total atomic concentration of K and Na in the bulk region, and "-2 at%" in this column means that the total atomic concentration of K and Na in the surface layer region is 2 at% lower than the total atomic concentration of K and Na in the bulk region.

[Table 2]

| Sample No. | Total atomic concentration of K and Na | | | DC stress life (h) | Piezoelectric constant $e_{31}$ $(C/m^2)$ |
| | Surface layer region (at%) | Bulk- region (at%) | Difference (at%) | | |
|---|---|---|---|---|---|
| 1 | 45 | 20 | +25 | 500 | $\geqq 8$ |
| 2 | 40 | 20 | +20 | >1000 | $\geqq 8$ |
| 3 | 30 | 20 | +10 | >1000 | $\geqq 8$ |
| 4 | 22 | 20 | +2 | >1000 | $\geqq 8$ |
| 5 | 20 | 20 | 0 | 500 | $\geqq 8$ |
| 6 | 18 | 20 | -2 | 300 | $\geqq 8$ |
| 7 | 45 | 22 | +23 | 500 | $\geqq 8$ |
| 8 | 40 | 22 | +18 | >1000 | $\geqq 8$ |
| 9 | 23 | 22 | +1 | >1000 | $\geqq 8$ |
| 10 | 22 | 22 | 0 | 600 | $\geqq 8$ |
| 11 | 20 | 22 | -2 | 400 | $\geqq 8$ |
| 12 | 45 | 19 | +26 | 400 | 8 |
| 13 | 40 | 19 | +21 | >1000 | $\geqq 8$ |
| 14 | 21 | 19 | +2 | >1000 | $\geqq 8$ |
| 15 | 19 | 19 | 0 | 500 | $\geqq 8$ |
| 16 | 18 | 19 | -1 | 300 | $\geqq 8$ |
| 17 | 45 | 18 | +27 | 350 | $\geqq 8$ |
| 18 | 40 | 18 | +12 | >1000 | $\geqq 8$ |
| 19 | 19 | 18 | +1 | >1000 | $\geqq 8$ |
| 20 | 18 | 18 | 0 | 450 | $\geqq 8$ |
| 21 | 17 | 18 | -1 | 300 | $\geqq 8$ |

It was confirmed that the stacks of samples 2 to 4, 8, 9, 13, 14, 18, and 19 all had a DC stress life of more than 1000 hours in the high temperature and high humidity environment. This shows that the total atomic concentration of K and Na in the surface layer region is higher than the total atomic concentration of K and Na in the bulk region, thereby improving the DC stress life in the high temperature and high humidity environment. It was also found that due to the 1 at% or more and 21 at% or less difference between the total atomic concentration of K and Na in the surface layer region and the total atomic concentration of K and Na in the bulk region, the DC stress life in the high temperature and high humidity environment can be reliably improved.

Further, it was confirmed that the stacks of samples 2 to 4, 8, 9, 13, 14, 18, and 19 all had a piezoelectric constant $e_{31}$ of 8 $C/m^2$ or more. This shows that increasing only the total atomic concentration of K and Na in the surface layer region does not affect the piezoelectric characteristics of the entire KNN film.

In contrast, it was confirmed that the stacks of samples 5, 6, 10, 11, 15, 16, 20, and 21 all had the DC stress life of 600 hours or less. This shows that in the stack in which the total atomic concentration of K and Na in the surface layer region is the same as or lower than the total atomic concentration of K and Na in the bulk region, the DC stress life in the high temperature and high humidity environment is shortened.

It was also confirmed that the stacks of samples 1, 7, 12, and 17 all had the DC stress life of 600 hours or less. This shows that when the total atomic concentration of K and Na in the surface layer region is higher than the total atomic concentration of K and Na in the bulk region, but when the difference between the total atomic concentration of K and Na in the surface layer region and the total atomic concentration of K and Na in the bulk region exceeds 21 at%, the total atomic concentration of K and Na in the surface layer region is likely to be 45 at% or more, which may result in a shortened DC stress life in the high temperature and high humidity environment. This is considered to be because the KNN crystals constituting the KNN film were unable to maintain the perovskite-type crystal structure, and the proportion of different crystal phases and amorphous substances mixed in the KNN film increased.

<Evaluation 2>

For each of samples 1 to 21, the deviation between the total atomic concentration of K and Na in the measurement length of 10 nm and the total atomic concentration of K and Na in the bulk region was evaluated.

(Measurement of the total atomic concentration of K and Na in the measurement length of 10 nm)

For each of samples 1 to 21, the total atomic concentration of K and Na in the measurement length of 10 nm was measured using the following equipment, conditions, and method.

Equipment: TOF SIMS5 manufactured by ION-TOF, Co., Ltd.

Measurement position: position including the center of the surface parallel to the surface direction of the substrate, of the KNN film that constitutes the bulk region
Measurement length: 10 nm in the film thickness direction
Measurement method: for each sample, TOF-SIMS was performed in the film thickness direction at the measurement position. Then, the total number of K and Na atoms contained in the KNN film at the measurement position when the measurement length was 10 nm in the film thickness direction, and the total number of atoms constituting the KNN film at the measurement position were calculated. At this time, on the assumption that the O atomic concentration of the KNN film was exactly 60 %, the total atomic concentration of K and Na in the measurement length of 10 nm was calculated using the above (Equation 3).

(Total atomic concentration of K and Na in the bulk region)

The measurement was performed in the same manner as the above Evaluation 1.

(Calculation of deviation)

For each of samples 1 to 21, the deviation between the total atomic concentration of K and Na in the measurement length of 10 nm and the total atomic concentration of K and Na in the bulk region was calculated.
In the KNN films constituting the bulk regions of samples 1 to 21, it was confirmed that the deviation between the total atomic concentration of K and Na in the measurement length of 10 nm and the total atomic concentration of K and Na in the bulk region was within 5 % at any position of the KNN film except for each interface region on the upper and lower sides. This shows that in the stacks of samples 1 to 21, the composition of the KNN film in the bulk region was almost uniform in the film thickness direction.

<Evaluation 3>

For each of samples 1 to 21, the deviation between the total atomic concentration of K and Na in the lower layer region and the total atomic concentration of K and Na in the bulk region was evaluated.

(Measurement of the total atomic concentration of K and Na in lower layer region)

For each of samples 1 to 21, the total atomic concentration of K and Na in the lower layer region of the bulk region was measured using the following equipment, conditions, and method.

Equipment: TOF SIMS5 manufactured by ION-TOF
Measurement method: for each sample, the total number of K and Na atoms in the lower layer region, and the total number of atoms in the KNN film constituting the lower layer region were calculated using TOF-SIMS. At this time, on the assumption that the O atomic concentration in the KNN film was exactly 60 %, the total atomic concentration of K and Na in the lower layer region was calculated using the above (Equation 4).
(Total atomic concentration of K and Na in the bulk region)

The measurement was performed in the same manner as the above Evaluation 1.

(Calculation of deviation)

For each of samples 1 to 21, the deviation between the total atomic concentration of K and Na in the lower layer region and the total atomic concentration of K and Na in the bulk region was calculated.

In the stacks of samples 1 to 21 in which the KNN film was deposited by sputtering, it was confirmed that the deviation between the total atomic concentration of K and Na in the lower layer region and the total atomic concentration of K and Na in the bulk region was within 5 %. This shows that in all of the stacks of samples 1 to 21, the diffusion of alkali metal elements into the bottom electrode film during deposition of the KNN film is suppressed.

<Preferable aspects of the present disclosure>

Preferable aspects of the present disclosure will be supplementarily described below.

(Supplementary description 1)

One aspect of the present disclosure provides a piezoelectric stack including:

a substrate;
a bottom electrode film on the substrate; and
a piezoelectric film on the bottom electrode film, the piezoelectric film being composed of a perovskite-type oxide represented by a general formula $ABO_3$, with A site containing K and Na, and B site containing Nb,
wherein when the piezoelectric film is divided into a surface layer region extending from an upper surface of the piezoelectric film to a predetermined depth toward the substrate, and a bulk region which is a region other than the surface layer region, a total atomic concentration of K and Na in the surface layer region is higher than a total atomic concentration of K and Na in the bulk region.

(Supplementary description 2)

The piezoelectric stack according to the supplementary description 1, wherein preferably, the surface layer region is a region extending from the upper surface of the piezoelectric film to a depth of 3 nm toward the substrate.

(Supplementary description 3)

The piezoelectric stack according to the supplementary description 1 or 2, wherein preferably, a difference between the total atomic concentration of K and Na in the surface layer region and the total atomic concentration of K and Na in the bulk region is 1 at% or more and 21 at% or less.

(Supplementary description 4)

The piezoelectric stack according to any one of the supplementary descriptions 1 to 3, wherein preferably, the total atomic concentration of K and Na in the surface layer region is less than 45 at%.

(Supplementary description 5)

The piezoelectric stack according to any one of the supplementary descriptions 1 to 4, wherein preferably, in the piezoelectric film constituting the bulk region, at a position including a center of a surface of the piezoelectric film parallel to a direction along a main surface of the substrate, a difference (deviation) between a total atomic concentration of K and Na when a measurement length is 10 nm in a film thickness direction and the total atomic concentration of K and Na in the bulk region is within 5 % at any position in the film thickness direction of the piezoelectric film except for each interface region on upper and lower sides.

(Supplementary description 6)

The piezoelectric stack according to any one of the supplementary descriptions 1 to 5, wherein preferably, a difference (deviation) between a total atomic concentration of K and Na in a lower layer region of the bulk region extending from a lower surface of the piezoelectric film to a height of 10 nm toward an upper surface of the piezoelectric film and the total atomic concentration of K and Na in the bulk region is within 5 %.

(Supplementary description 7)

The piezoelectric stack according to any one of the supplementary descriptions 1 to 6, wherein preferably, the piezoelectric film has a piezoelectric constant $e_{31}$ of 8 $C/m^2$ or more.

(Supplementary description 8)

The piezoelectric stack according to any one of the supplementary descriptions 1 to 7, wherein preferably, the piezoelectric film is a polycrystalline film of the perovskite-type oxide, or a single crystalline film of the perovskite-type oxide.

(Supplementary description 9)

A method for manufacturing a piezoelectric stack, including:

preparing a substrate;
depositing a bottom electrode film on the substrate;
preparing a target composed of a perovskite-type oxide represented by a general formula $ABO_3$, with A site containing K and Na, and B site containing Nb; and
depositing a piezoelectric film composed of a perovskite-type oxide represented by a general formula $ABO_3$, with A site containing K and Na, and B site containing Nb, on the bottom electrode film by a sputtering method using the target;
wherein in the preparation of the target, a first target, and a second target in which a ratio of a total number of K and Na atoms contained per unit volume with respect to the number of Nb atom contained per unit volume is smaller than that of the first target, are prepared, and
in the deposition of the piezoelectric film, (a) applying equal power to the first target and the second target; and (b) applying a power to the first target that is greater than a power to the second target, are performed in this order by using the first target and the second target, wherein (b) is started immediately before an end of deposition of the piezoelectric film.

(Supplementary description 10)

Further another aspect of the present disclosure provides a piezoelectric stack substrate or piezoelectric element (piezoelectric device module), including:

a substrate;
a bottom electrode film on the substrate; and
a piezoelectric film on the bottom electrode film, the piezoelectric film being composed of a perovskite-type oxide represented by a general formula $ABO_3$, with A site containing K and Na, and B site containing Nb,
wherein when the piezoelectric film is divided into a surface layer region extending from an upper surface of the piezoelectric film to a predetermined depth toward the substrate, and a bulk region which is a region other than the surface layer region, a total atomic concentration of K and Na in the surface layer region is higher than a total atomic concentration of K and Na in the bulk region.

Description of signs and numerals

1. Substrate
2. Bottom electrode film
3. Piezoelectric film

3a. Piezoelectric film constituting a surface layer region

3b. Piezoelectric film constituting a bulk region

3b 1. Piezoelectric film constituting a lower layer region of the bulk region

3b2. Piezoelectric film constituting the bulk region other than the lower layer region

4. Top electrode film

6. Bottom adhesive layer

7. Top adhesive layer

10. Piezoelectric stack

20. Piezoelectric element

30. Piezoelectric device module

**Claims**

1. A piezoelectric stack comprising:

   a substrate;
   a bottom electrode film on the substrate; and
   a piezoelectric film on the bottom electrode film, the piezoelectric film being composed of a perovskite-type oxide represented by a general formula $ABO_3$, with A site containing K and Na, and B site containing Nb,
   wherein when the piezoelectric film is divided into a surface layer region extending from an upper surface of the piezoelectric film to a predetermined depth toward the substrate, and a bulk region which is a region other than the surface layer region, a total atomic concentration of K and Na in the surface layer region is higher than a total atomic concentration of K and Na in the bulk region.

2. The piezoelectric stack according to claim 1, wherein the surface layer region is a region extending from the upper surface of the piezoelectric film to a depth of 3 nm toward the substrate.

3. The piezoelectric stack according to claim 1 or 2, wherein a difference between the total atomic concentration of K and Na in the surface layer region and the total atomic concentration of K and Na in the bulk region is 1 at% or more and 21 at% or less.

4. The piezoelectric stack according to claim 1 or 2, wherein in the piezoelectric film constituting the bulk region, at a position including a center of a surface of the piezoelectric film parallel to a direction along a main surface of the substrate, a difference between a total atomic concentration of K and Na when a measurement length is 10 nm in a film thickness direction and the total atomic concentration of K and Na in the bulk region is within 5 % at any position in the film thickness direction of the piezoelectric film except for each interface region on upper and lower sides.

5. The piezoelectric stack according to claim 1 or 2, wherein a difference between a total atomic concentration of K and Na in a lower layer region of the bulk region extending from a lower surface of the piezoelectric film to a height of 10 nm toward an upper surface of the piezoelectric film and the total atomic concentration of K and Na in the bulk region is within 5 %.

6. The piezoelectric stack according to claim 1 or 2, wherein the piezoelectric film has a piezoelectric constant $e_{31}$ of 8 $C/m^2$ or more.

7. The piezoelectric stack according to claim 1 or 2, wherein the piezoelectric film is a polycrystalline film of the perovskite-type oxide, or a single crystalline film of the perovskite-type oxide.

8. A method for manufacturing a piezoelectric stack, comprising:

   preparing a substrate;
   preparing a target composed of a perovskite-type oxide represented by a general formula $ABO_3$, with A site containing K and Na, and B site containing Nb;
   depositing a bottom electrode film on the substrate; and
   depositing a piezoelectric film composed of a perovskite-type oxide represented by a general formula $ABO_3$, with A site containing K and Na, and B site containing Nb, on the bottom electrode film by a sputtering method using the target,

wherein in the preparation of the target,

a first target, and a second target in which a ratio of a total number of K and Na atoms contained per unit volume with respect to the number of Nb atom contained per unit volume is smaller than that of the first target, are prepared, and

in the deposition of the piezoelectric film,

(a) applying equal power to the first target and the second target; and (b) applying a power to the first target that is greater than a power to the second target, are performed in this order by using the first target and the second target, wherein (b) is started immediately before an end of deposition of the piezoelectric film.

**FIG. 1**

**FIG. 2**

## FIG. 3

## FIG. 4

## FIG. 5

# FIG. 6

(a)

(b)

# EUROPEAN SEARCH REPORT

**Application Number**

EP 25 18 6327

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2017/229637 A1 (SAKAI TOMOHIRO [JP] ET AL) 10 August 2017 (2017-08-10)<br>* paragraph [0114] - paragraph [0115]; figures 15, 16 * | 1-8 | INV.<br>H10N30/076<br>H10N30/079<br>H10N30/00<br>H10N30/853 |
| A | EP 3 382 766 A1 (SEIKO EPSON CORP [JP]) 3 October 2018 (2018-10-03)<br>* paragraph [0092] - paragraph [0098]; figures 13-23 * | 1-8 | ADD.<br>H10N30/20 |
| A | EP 3 531 460 A1 (SEIKO EPSON CORP [JP]) 28 August 2019 (2019-08-28)<br>* paragraph [0111] - paragraph [0119]; figures 17-19 * | 1-8 | |

**TECHNICAL FIELDS SEARCHED (IPC)**

H10N

The present search report has been drawn up for all claims

| Place of search | Date of completion of the search | Examiner |
|---|---|---|
| Munich | 21 November 2025 | Gröger, Andreas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 18 6327

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2025

| Patent document cited in search report | | | Publication date | Patent family member(s) | | | Publication date |
|---|---|---|---|---|---|---|---|
| US 2017229637 | A1 | | 10-08-2017 | CN | 107053848 | A | 18-08-2017 |
| | | | | JP | 6866662 | B2 | 28-04-2021 |
| | | | | JP | 2017143260 | A | 17-08-2017 |
| | | | | US | 2017229637 | A1 | 10-08-2017 |
| | | | | US | 2020035905 | A1 | 30-01-2020 |
| EP 3382766 | A1 | | 03-10-2018 | CN | 108656749 | A | 16-10-2018 |
| | | | | EP | 3382766 | A1 | 03-10-2018 |
| | | | | JP | 6922326 | B2 | 18-08-2021 |
| | | | | JP | 2018166187 | A | 25-10-2018 |
| | | | | US | 2018287048 | A1 | 04-10-2018 |
| EP 3531460 | A1 | | 28-08-2019 | EP | 3531460 | A1 | 28-08-2019 |
| | | | | JP | 7087442 | B2 | 21-06-2022 |
| | | | | JP | 2019149456 | A | 05-09-2019 |
| | | | | US | 2019267537 | A1 | 29-08-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017076730 A

- JP 2018207055 A